# EUROPEAN PATENT APPLICATION

(11) **EP 4 715 434 A1**
(43) Date of publication of application: **25.03.2026**
(21) Application number: 24835322.9
(22) Date of filing: 01.07.2024
(51) Int. Cl.: G02B 6/38

(54) **OPTICAL SIGNAL ADAPTER ASSEMBLY HAVING LOSSY WAVEGUIDE, AND OPTICAL SIGNAL ADAPTER SYSTEM**

(30) Priority: 03.07.2023 CN 202310811045
(71) Applicant: Huawei Technologies Co., Ltd., Shenzhen, Guangdong 518129 (CN)
(72) Inventor: CHENG, Dingning, Shenzhen, Guangdong 518129 (CN); ZHAO, Caijun, Shenzhen, Guangdong 518129 (CN); DING, Xueying, Shenzhen, Guangdong 518129 (CN)
(74) Representative: Gill Jennings & Every LLP
(86) International application number: PCT/CN2024/102963
(87) International publication number: WO 2025/007841

(57) **Abstract**

This application relates to the field of communication technologies, and discloses an optical signal adapter assembly with a lossy waveguide, a connection core, a connector structure, an adapter structure, an optical signal adapter system, and an electronic device. The optical signal adapter assembly includes a connector core, an adapter, a first conductive layer, and a second conductive layer. The connector core is made of a plastic material. A plastic base material of the adapter is doped with a conductive filler and/or a magnetic filler. A slot is provided in the adapter, and the connector core is inserted in the slot. The first conductive layer is located between the connector core and the adapter and encloses the connector core. The second conductive layer encloses the adapter. A waveguide structure in the optical signal adapter assembly can change a transmission path of electromagnetic waves, so that the transmission path of the electromagnetic waves falls as much as possible into an area in which the adapter is located, thereby increasing an electromagnetic wave loss caused by the adapter. Based on this, the electromagnetic wave loss can be increased, and a shielding effect can be improved.

## Description

This application claims priority to Chinese Patent Application No. 202310811045.6, filed with the China National Intellectual Property Administration on July 3, 2023 and entitled "OPTICAL SIGNAL ADAPTER ASSEMBLY WITH LOSSY WAVEGUIDE AND OPTICAL SIGNAL ADAPTER SYSTEM", which is incorporated herein by reference in its entirety.

### TECHNICAL FIELD

This application relates to the communication field, and in particular, to an optical signal adapter assembly with a lossy waveguide, a connector core, a connector structure, an adapter structure, an optical signal adapter system, and an electronic device.

### BACKGROUND

With the advent of the big data era, an optical signal adapter system is widely used as an important means for big data transmission. The optical signal adapter system implements signal transmission between two optical fibers by using an optical signal adapter assembly. In addition, an electronic product in the optical signal adapter system generates electromagnetic noise (electromagnetic noise, EMN). The electromagnetic noise refers to a random variation in an electrical signal, caused by thermal vibration of a circuit component or other factors, and is an electromagnetic wave that can interfere with or interrupt normal running of an electronic device. The electromagnetic noise interferes with other surrounding electronic products. To ensure performance of various electronic products in an electronic system, only electronic products that have passed related tests, such as electromagnetic compatibility (electromagnetic compatibility, EMC) certification, can be marketed. Electromagnetic compatibility refers to capabilities of electronic devices to be compatible with each other without mutual interference under different operating conditions.

With development of communication technologies, an operating speed of a chip in an electronic product continuously increases, causing a frequency range for electromagnetic radiation testing in EMC certification of the electronic product to expand from 30 MHz-1 GHz to 30 MHz-6 GHz. The U.S. FCC (Federal Communications Commission) standard requires that the frequency range for electromagnetic radiation testing in electronic product certification should be expanded to 30 MHz-40 GHz. Electromagnetic waves generated by an electromagnetic radiation source in the electronic product propagate through space and leak directly from an optical signal adapter assembly, causing the product to fail to meet a market entry certification requirement.

### SUMMARY

In view of this, embodiments of this application provide an optical signal adapter assembly with a lossy waveguide, a connector core, a connector structure, an adapter structure, and an optical signal adapter system. The optical signal adapter assembly includes a connector core, an adapter, a first conductive layer, and a second conductive layer. The connector core is made of a plastic material. A plastic base material of the adapter is doped with a conductive filler and/or a magnetic filler. A slot is provided in the adapter, and the connector core is inserted in the slot. The first conductive layer is located between the connector core and the adapter and encloses the connector core. The second conductive layer encloses the adapter. The second conductive layer, the adapter, the first conductive layer, and a connector form a concentric-square waveguide structure. A medium in the concentric-square waveguide structure is a plastic material filled with a conductive filler and/or a magnetic filler. The waveguide structure in the optical signal adapter assembly can change a transmission path of electromagnetic waves, so that the transmission path of the electromagnetic waves falls as much as possible into an area in which the adapter is located, thereby increasing an electromagnetic wave loss caused by the adapter. Based on this, the electromagnetic wave loss can be increased, and a shielding effect can be improved.

A first aspect of this application provides an optical signal adapter assembly. The optical signal adapter assembly is configured to connect a first optical module to a second optical module to implement transmission of an optical signal from the first optical module to the second optical module. The optical signal adapter assembly includes a connector core, a first conductive layer, an adapter, and a second conductive layer. The connector core is configured to connect to an optical module. The first conductive layer encloses the connector core around a transmission axis, and the transmission axis is parallel to a transmission direction of the optical signal. A material of the adapter includes a conductive filler and/or a magnetic filler, and the adapter encloses the first conductive layer around the transmission axis. The second conductive layer encloses the adapter around the transmission axis.

The optical module includes but is not limited to an optical fiber and an optical transceiver module. The connector core may be a ferrule in the connector, or may be an optical component adapted to the optical transceiver module. This is not specifically limited in this application. The transmission axis may extend along an insertion direction in which the connector core is inserted into the adapter.

In other words, in an implementation of this application, along the transmission axis, the first conductive layer is provided on an outer circumferential surface of the connection core, the adapter is provided on an outer circumferential surface of the first conductive layer, and the second conductive layer is provided on an outer circumferential surface of the adapter. Based on this, the first conductive layer and the second conductive layer form a concentric-square waveguide structure extending along the transmission axis. In other words, the concentric-square waveguide structure sequentially includes the connector core, the first conductive layer, the adapter, and the second conductive layer from inside to outside along a radial direction. The radial direction is perpendicular to the transmission axis. The optical signal adapter assembly can effectively limit a transmission path of electromagnetic waves within the optical signal adapter assembly. In addition, because the material of the adapter includes the conductive filler and/or the magnetic filler, a lossy medium exists between the two layers of metal walls in the concentric-square waveguide structure, thereby increasing an electromagnetic wave loss caused by the adapter. Based on this, the waveguide structure in the optical signal adapter assembly can increase the electromagnetic wave loss and improve a shielding effect.

In some possible implementations of the first aspect, in the optical signal adapter assembly, the first conductive layer is formed on one of two opposite surfaces of the connector core and the adapter. In other words, in an implementation of this application, when the optical signal adapter assembly is in an assembled state, the first conductive layer is located between the connector core and the adapter, thereby reducing a quantity of components in the optical signal adapter assembly in this application and reducing difficulty in mounting or assembling the optical signal adapter assembly. Whether the first conductive layer is formed on the connector core or the adapter is not specifically limited in this application. In addition, a method for forming the conductive layer in this application is described in detail later, and details are not described herein.

In some possible implementations of the first aspect, in the optical signal adapter assembly, a mass doping percentage of the conductive filler and/or the magnetic filler ranges from 0.5% to 40%. The mass doping percentage of the conductive filler and/or the magnetic filler is a percentage of an accumulated weight of the conductive filler and/or the magnetic filler to a total massof the adapter. The total weight of the adapter is a sum of masses of the conductive filler and/or the magnetic filler and a plastic base material. For the optical signal adapter assembly, by properly designing the mass doping percentage of the conductive filler and/or the magnetic filler, an electromagnetic wave loss effect can be effectively improved, and a shielding effect of the optical signal adapter assembly can be effectively improved.

In some possible implementations of the first aspect, in the optical signal adapter assembly, the first conductive layer is a film-like structure that rotates around the transmission axis; and/or the second conductive layer is a film-like structure that rotates around the transmission axis. In the optical signal adapter assembly, the first conductive layer and the second conductive layer are thin-film-like structures that rotate around the transmission axis, having little impact on a size of an existing structure, so that an application scope of the technical solutions of this application can be expanded. For example, a thickness of the first conductive layer ranges from 1 µm to 500 µm; and/or a thickness of the second conductive layer ranges from 1 µm to 500 µm.

In some possible implementations of the first aspect, in the optical signal adapter assembly, the first conductive layer includes a first conductive sublayer and a second conductive sublayer, and the first conductive sublayer and the second conductive sublayer cooperate with each other to enclose the connector core around the transmission axis; and the first conductive sublayer is formed on a surface that is of the connector core and that faces toward the adapter, and the second conductive sublayer is formed on a surface that is of the adapter and that faces toward the connector core.

In other words, in an implementation of this application, the first conductive layer includes two parts: the first conductive sublayer and the second conductive sublayer. In addition, the first conductive sublayer is disposed on the surface that is of the connector core and that faces toward the adapter, and the second conductive sublayer is disposed on the surface that is of the adapter and that faces toward the adapter. In this application, after the first conductive sublayer and the second conductive sublayer are integrated, the first conductive sublayer and the second conductive sublayer can enclose the connector core around the transmission axis, and forms of the first conductive sublayer and the second conductive sublayer are not specifically limited. In the optical signal adapter assembly, the first conductive layer may alternatively be a split structure separately formed on the connector core and the adapter, thereby extending an implementation of the first conductive layer and reducing design difficulty and formation difficulty of the first conductive layer.

In some possible implementations of the first aspect, the second conductive layer is formed on a surface that is of the adapter and that faces away from the connector core. In other words, in an implementation of this application, the second conductive layer is formed on an outer surface of the adapter. In the optical signal adapter assembly, because the second conductive layer does not need to be separately disposed as a component, the quantity of components in the optical signal adapter assembly is reduced, assembly difficulty is reduced, and overall precision is improved. In addition, because the second conductive layer is formed on the outer surface of the adapter, formation difficulty is reduced, production costs are reduced, and economic benefits of the optical signal adapter assembly are improved.

In some possible implementations of the first aspect, the optical signal adapter assembly further includes a conductive housing, the connector core, the first conductive layer, and the adapter are located in the conductive housing, and the conductive housing is used as the second conductive layer. For example, a thickness of the conductive housing is greater than 1 µm. In other words, in an implementation of this application, the second conductive layer is a separately disposed component, and another component in the optical signal adapter assembly may be accommodated in this component. Because the conductive housing is disposed in the optical signal adapter assembly, and the conductive housing is used as the second conductive layer, a sealing design of the optical signal adapter assembly is implemented, and system stability can be improved.

In some possible implementations of the first aspect, the optical signal adapter assembly includes a conductive housing, and at a connection point, the connector core, the first conductive layer, the adapter, and the second conductive layer are located in the conductive housing. The second conductive layer includes a third conductive sublayer and a fourth conductive sublayer, and the third conductive sublayer and the fourth conductive sublayer cooperate with each other to enclose the adapter around the transmission axis. The third conductive sublayer is formed on a surface of the adapter, and the fourth conductive sublayer is formed on a surface of the conductive housing. In this way, the optical signal adapter assembly further expands the application scope.

In some possible implementations of the first aspect, the conductive filler includes but is not limited to at least one of a carbon fiber, a nickel-coated carbon fiber, a metal conductive particle, a metal conductive fiber, carbon black, graphite, and a carbon nanotube. For the optical signal adapter assembly, by properly designing the type of the conductive filler, the electromagnetic wave loss effect can be effectively improved, and the shielding effect of the optical signal adapter assembly can be effectively improved.

In some possible implementations of the first aspect, the magnetic filler includes but is not limited to at least one of ferrite, iron powder, nickel-iron powder, nickel-zinc ferrite, ferric hydroxide, and magnetic ceramics. For the optical signal adapter assembly, by properly designing the type of the magnetic filler, the electromagnetic wave loss effect can be effectively improved, and the shielding effect of the optical signal adapter assembly can be effectively improved.

In some possible implementations of the first aspect, opposite surfaces of the connector core and the first conductive layer are in sealed contact with each other, and the connector core is made of a conductive material. In other words, in this application, the optical module is an optical transceiver module, the connector core is an optical component connected to the optical transceiver module, and the optical component is made of a conductive material. For the optical signal adapter assembly, the conductive material of the optical component can prevent the electromagnetic waves from being radiated directly from the connector core. Based on this, the foregoing structure can further optimize the transmission path of the electromagnetic waves, so that as many electromagnetic waves as possible fall into an area in which the adapter is located, thereby further increasing the electromagnetic wave loss caused by the adapter. Based on this, the foregoing waveguide structure can further increase the electromagnetic wave loss, and therefore can further improve the shielding effect of the optical signal adapter assembly.

In some possible implementations of the first aspect, the optical signal adapter assembly further includes a third conductive layer, and the third conductive layer is disposed on the connector core and extends along a direction intersecting the transmission axis, until the third conductive layer is in sealed contact with a surface of the first conductive layer. In other words, in this application, the optical module is an optical fiber, and the connector core is a ferrule connected to the optical fiber. In the optical signal adapter assembly, the third conductive layer is disposed on the ferrule, and the third conductive layer is configured to block a cylindrical channel formed by the first conductive layer, thereby preventing the electromagnetic waves from being radiated directly from the ferrule (that is, the connector core). Based on this, the foregoing structure can further optimize the transmission path of the electromagnetic waves, so that as many electromagnetic waves as possible fall into an area in which the adapter is located, thereby further increasing the electromagnetic wave loss caused by the adapter. Based on this, the foregoing waveguide structure can further increase the electromagnetic wave loss, and therefore can further improve the shielding effect of the optical signal adapter assembly.

It may be understood that, in some other implementations of this application, a position at which the third conductive layer is disposed on the ferrule is not specifically limited in this application. Any form that can prevent the electromagnetic waves from being radiated and leaked directly from the ferrule falls within the protection scope of this application.

In some possible implementations of the first aspect, in the optical signal adapter assembly, the third conductive layer is a film-like structure that is perpendicular to the transmission axis. For example, a thickness of the third conductive layer ranges from 1 µm to 500 µm. In the optical signal adapter assembly, the third conductive layer is a thin-film-like structure that rotates around the transmission axis, having little impact on the size of the existing structure, so that the application scope of the technical solutions of this application can be expanded.

A second aspect of this application provides a connector structure. The connector structure includes a connector core and a fourth conductive layer. The connector core is configured to connect to an optical module. The fourth conductive layer at least partially encloses the connector core around a transmission axis, and the transmission axis is parallel to a transmission direction. It may be understood that the fourth conductive layer is a first conductive layer formed on the connector core and that the connector structure is a connector provided with a conductive layer. Details are not described herein. In the connector structure, the fourth conductive layer is formed on the connector core and corresponds to the foregoing technical solution in which the first conductive layer is formed on the connector core, to reduce a quantity of components in an optical signal adapter assembly and reduce difficulty in mounting or assembling the optical signal adapter assembly.

In some possible implementations of the second aspect, the connector structure includes but is not limited to at least one of a multipurpose push-on/pull-off connector, a lucent connector, a standard connector, and an active optical cable connector.

A third aspect of this application provides an adapter structure. The connector structure includes a fifth conductive layer and an adapter. The fifth conductive layer is formed in an annular shape around a transmission axis. A material of the adapter includes a conductive filler and/or a magnetic filler, and the adapter encloses the fifth conductive layer around the transmission axis. It may be understood that the fifth conductive layer is a first conductive layer formed on the adapter and that the adapter structure is an adapter provided with a conductive layer. Details are not described herein. The adapter structure corresponds to the foregoing technical solution in which the first conductive layer is formed on the adapter, to reduce a quantity of components in an optical signal adapter assembly and reduce difficulty in mounting or assembling the optical signal adapter assembly.

In some possible implementations of the third aspect, the conductive filler includes but is not limited to at least one of a carbon fiber, a nickel-coated carbon fiber, a metal conductive particle, a metal conductive fiber, carbon black, graphite, and a carbon nanotube. For the optical signal adapter assembly, by properly designing the type of the conductive filler, an electromagnetic wave loss effect can be effectively improved, and a shielding effect of the optical signal adapter assembly can be effectively improved.

In some possible implementations of the third aspect, the magnetic filler includes but is not limited to at least one of ferrite, iron powder, nickel-iron powder, nickel-zinc ferrite, ferric hydroxide, and magnetic ceramics. For the optical signal adapter assembly, by properly designing the type of the magnetic filler, the electromagnetic wave loss effect can be effectively improved, and the shielding effect of the optical signal adapter assembly can be effectively improved.

A fourth aspect of this application provides an adapter structure. The adapter structure includes an adapter and a sixth conductive layer. The adapter includes a conductive filler and/or a magnetic filler, a slot for inserting a connector core is provided in the adapter, and the slot extends along a transmission direction. The sixth conductive layer at least partially encloses the adapter around a transmission axis, and the transmission axis is parallel to the transmission direction. It may be understood that the sixth conductive layer is a second conductive layer formed on the adapter and that the adapter structure is an adapter provided with a conductive layer. Details are not described herein. The adapter structure corresponds to the foregoing technical solution in which the second conductive layer is formed on the adapter, to reduce a quantity of components in an optical signal adapter assembly and reduce difficulty in mounting or assembling the optical signal adapter assembly.

In some possible implementations of the fourth aspect, the conductive filler includes but is not limited to at least one of a carbon fiber, a nickel-coated carbon fiber, a metal conductive particle, a metal conductive fiber, carbon black, graphite, and a carbon nanotube. For the optical signal adapter assembly, by properly designing the type of the conductive filler, an electromagnetic wave loss effect can be effectively improved, and a shielding effect of the optical signal adapter assembly can be effectively improved.

In some possible implementations of the fourth aspect, the magnetic filler includes but is not limited to at least one of ferrite, iron powder, nickel-iron powder, nickel-zinc ferrite, ferric hydroxide, and magnetic ceramics. For the optical signal adapter assembly, by properly designing the type of the magnetic filler, the electromagnetic wave loss effect can be effectively improved, and the shielding effect of the optical signal adapter assembly can be effectively improved.

A fifth aspect of this application provides an adapter structure. The adapter structure includes a fifth conductive layer, an adapter, and a sixth conductive layer. The adapter structure corresponds to the foregoing technical solution in which the first conductive layer and the second conductive layer are formed on the adapter, to reduce a quantity of components in an optical signal adapter assembly and reduce difficulty in mounting or assembling the optical signal adapter assembly.

A sixth aspect of this application provides an optical signal adapter system. The optical signal adapter system includes the optical signal adapter assembly in any one of the first aspect and the possible implementations of the first aspect, and two optical modules, where the two optical modules implement optical signal adaptation by using the optical adapter assembly.

A seventh aspect of this application provides an electronic device. The electronic device includes any optical signal adapter system in the sixth aspect.

### BRIEF DESCRIPTION OF DRAWINGS

FIG. 1(a) is a diagram of an optical signal adapter system S1 in some application scenarios of this application;
FIG. 1(b) is a side view of an optical component 100a according to some embodiments of this application;
FIG. 1(c) is a sectional view along an M-M section in FIG. 1(b);
FIG. 1(d) is a sectional view of an optical component 100a and an optical transceiver module 1a in an assembled state along a section in FIG. 1(b);
FIG. 1(e) is a side view of an optical fiber connector 100b according to some embodiments of this application;
FIG. 1(f) is a sectional view along an N-N section in FIG. 1(e);
FIG. 1(g) is a sectional view of an optical fiber connector 100b and an optical fiber 1b in an assembled state along an N-N section in FIG. 1(e);
FIG. 1(h) is a sectional view of an optical transceiver module 1a, an optical component 100a, an optical fiber 1b, an optical fiber connector 100b, and an adapter 200 along an N-N section in FIG. 1(e) according to some embodiments of this application;
FIG. 1(i) is a diagram of an optical signal adapter system S2 in some application scenarios of this application;
FIG. 2 is an exploded view of an optical signal adapter assembly 2 according to some embodiments of this application;
FIG. 3(a) is a three-dimensional view of an adapter 200 from another angle according to some embodiments of this application;
FIG. 3(b) is a perspective view after a connector module 100 and an adapter 200 are assembled according to some embodiments of this application;
FIG. 3(c) is a three-dimensional view after a connector module 100, an adapter 200, and a housing 300 are assembled according to some embodiments of this application;
FIG. 4(a) is a sectional view of an optical signal adapter assembly 2 along an A-A section in FIG. 3(c) according to some embodiments of this application;
FIG. 4(b) is a sectional view of an optical signal adapter assembly 2 along a B-B section in FIG. 3(c) according to some embodiments of this application;
FIG. 5 is a partial enlarged view of an area S1 in FIG. 4(b) according to some embodiments of this application, where a transmission path of electromagnetic waves of an electronic device in a waveguide structure in an optical signal adapter assembly 2 is illustrated;
FIG. 6 is a partial enlarged view of an area S1 in FIG. 4(b) according to some other embodiments of this application, where a transmission path of electromagnetic waves in a waveguide structure in an optical signal adapter assembly 2 is illustrated;
FIG. 7(a) is a sectional view of an optical signal adapter assembly 2 along an A-A section in FIG. 3(c) according to some other embodiments of this application;
FIG. 7(b) is a partial enlarged view of an area S1 in FIG. 4(b) in some other embodiments of this application, where a transmission path of electromagnetic waves in a waveguide structure is illustrated;
FIG. 8 is a diagram illustrating a shielding effect of an optical signal adapter solution applicable to an MPO connector according to some embodiments of this application;
FIG. 9 is a partial enlarged view of an area S1 in FIG. 4(b) according to still some other embodiments of this application;
FIG. 10(a) is an exploded view of an optical signal adapter system S2 according to some embodiments of this application;
FIG. 10(b) is a three-dimensional view of an optical signal adapter system S2 in FIG. 10(a);
FIG. 11(a) is a sectional view of an optical signal adapter assembly 2 along a C-C section in FIG. 10(b) according to some embodiments of this application;
FIG. 11(b) is a sectional view of an optical signal adapter assembly 2 along a D-D section in FIG. 10(b) according to some embodiments of this application;
FIG. 11(c) is a partial enlarged view of an area S2 in FIG. 11(b) according to some embodiments of this application, where a transmission path of electromagnetic waves in a waveguide structure is illustrated;
FIG. 12 is a diagram of a housing 300 according to some embodiments of this application;
FIG. 13 is a diagram of a conductive layer 400 formed on a first ferrule 110c according to some embodiments of this application;
FIG. 14 is a diagram of a conductive layer 400 formed on an adapter 200 according to some embodiments of this application;
FIG. 15 is a sectional view of an optical signal adapter assembly 2 along a C-C section in FIG. 10(b) according to some other embodiments of this application;
FIG. 16(a) is a diagram of a first conductive sublayer 410 formed on a ferrule 110c according to some other embodiments of this application;
FIG. 16(b) is a diagram of a second conductive sublayer 420 formed on an adapter 200 according to some other embodiments of this application;
FIG. 17 is a sectional view of an optical signal adapter assembly 2 along a C-C section in FIG. 10(b) according to some other embodiments of this application;
FIG. 18(a) is a diagram of a first conductive sublayer 410 formed on a ferrule 110c according to some other embodiments of this application;
FIG. 18(b) is a diagram of a second conductive sublayer 420 formed on an adapter 200 according to some other embodiments of this application;
FIG. 19 is a sectional view obtained by cutting an optical signal adapter assembly 2 along a D-D section in FIG. 10(b) according to some embodiments of this application, where a first ferrule 110c is not shown;
FIG. 20(a) is a partial enlarged view of an area S2 in FIG. 11(b) according to some embodiments of this application, where transmission paths of electromagnetic waves W1 and W2 in a waveguide structure are illustrated;
FIG. 20(b) is a partial enlarged view of an area S2 in FIG. 11(b) in some other embodiments of this application, where transmission paths of electromagnetic waves W1 and W2 in a waveguide structure are illustrated;
FIG. 20(c) is a partial enlarged view of an area S2 in FIG. 11(b) in some other embodiments of this application, where transmission paths of electromagnetic waves W1 and W2 in a waveguide structure are illustrated;
FIG. 21 is a sectional view of an optical signal adapter assembly 2' along a C-C section in FIG. 10(b) according to some embodiments of this application;
FIG. 22 is a diagram of a conductive layer 600 formed on an adapter 200 in an optical signal adapter system 2' according to some embodiments of this application;
FIG. 23 is a sectional view of an optical signal adapter assembly 2" along a C-C section in FIG. 10(b) according to some embodiments of this application;
FIG. 24(a) is a diagram of a housing 300 in an optical signal adapter assembly 2" according to some embodiments of this application;
FIG. 24(b) is a diagram of a conductive layer 600 formed on an adapter 200 in an optical signal adapter assembly 2" according to some embodiments of this application;
FIG. 25 is a three-dimensional view of an optical signal adapter system S1 according to some embodiments of this application;
FIG. 26 is a sectional view of an optical signal adapter system S1 along an E-E section in FIG. 25 according to some embodiments of this application; and
FIG. 27 is a partial enlarged view of an area S3 in FIG. 26.

### Reference numerals:

1a-optical transceiver module; 1b-optical fiber; 1c-first optical fiber; 1d-second optical fiber;
11a-processing module; 11b-body; 12a-optical fiber; 12b-fiber core; 13a-fiber core; 110-connector core;
100-connector module; 100a-optical component; 100b-optical fiber connector; 100c-optical fiber connector; 100d-optical fiber connector; 110a-optical component base; 110b-ferrule; 110c-first connector core; 110d-second ferrule; 111a-first optical component end face; 111b-first ferrule end face; 112a-second optical component end face; 112b-second ferrule end face; 120a-optical fiber hole; 120b-optical fiber hole; 130a-positioning post; 130b-protective component; 131b-first protective end face; 132b-second protective end face; 140b-protective hole;
2-optical signal adapter assembly;
200-adapter; 210-adapter body; 211-first mating surface; 212-second mating surface; 220-first mating hole; 230-second mating hole;
300-housing; 310-first housing; 320-second housing;
400-conductive layer; 410-first conductive sublayer; 420-second conductive sublayer;
500-conductive layer; 510-third conductive sublayer; 520-fourth conductive sublayer;
600-conductive layer;
700-conductive structure.

### DESCRIPTION OF EMBODIMENTS

To make objectives, technical solutions, and advantages of this application clearer, the following further describes implementations of this application in detail with reference to the accompanying drawings.

An optical signal adapter solution provided in this application can be applied to an optical signal adapter system for optical signal adaptation. The optical signal adapter system includes a first optical module, a second optical module, and an optical signal adapter assembly. The first optical module and the second optical module may each be at least one of an optical fiber and an optical module. The optical signal adapter assembly includes a first connector module, a second connector module, and an adapter. The first connector module is configured to secure the first optical module, and the second connector module is configured to secure the second optical module. Moreover, a first connector core in the first connector module and a second connector core in the second connector module each cooperate with an adapter interface on the adapter, so that the first optical module corresponding to the first connector module is connected to the second optical module corresponding to the second connector module (for example, a fiber core of a first optical fiber is connected to a fiber core of a second optical fiber), thereby implementing optical signal adaptation between the first optical module and the second optical module. In addition, the optical signal adapter solution provided in this application is further applicable to the optical signal adapter assembly, the connector core, the connector module, and the adapter. This is not specifically limited in this application.

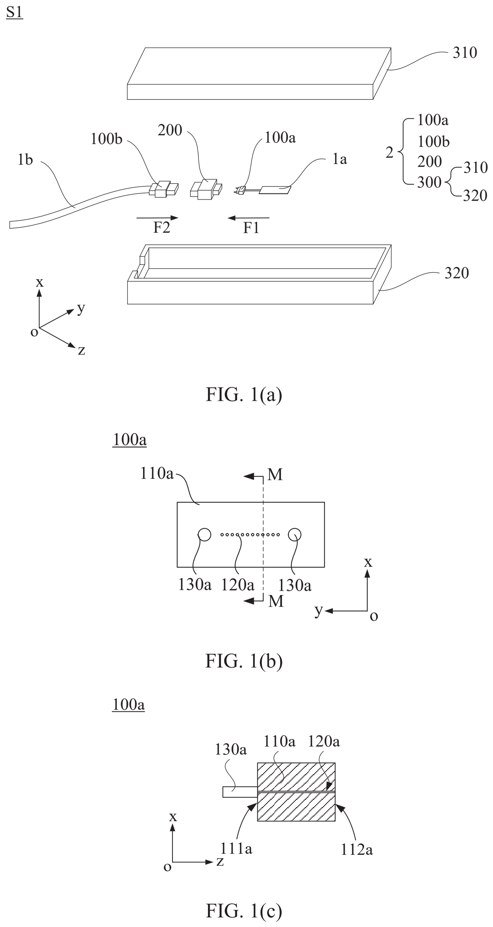

The optical signal adapter solution provided in this application can be applied to an application scenario in which an optical fiber is connected to an optical transceiver module. The following provides brief descriptions with reference to the accompanying drawings. In the field of optical communication, securing and interconnection of an optical transceiver module and an optical fiber are generally achieved through cooperation of an optical component, an adapter, and an optical fiber connector. FIG. 1(a) is a diagram of an optical signal adapter system S1 in some application scenarios of this application. As shown in FIG. 1(a), the optical signal adapter system S1 includes an optical transceiver module 1a, an optical fiber 1b, and an optical signal adapter assembly 2. The optical transceiver module 1a and the optical fiber 1b are interconnected by the optical signal adapter assembly 2, so that optical signal transmission is implemented between the optical transceiver module 1a and the optical fiber 1b. The optical signal adapter assembly 2 includes an optical component 100a, an optical fiber connector 100b, an adapter 200, and a housing 300. The optical component 100a is connected to the optical transceiver module 1a, and is disposed in the housing 300. The optical transceiver module 1a includes a circuit board (not shown in the figure) and a photoelectric conversion module (not shown in the figure), and the photoelectric conversion module is electrically connected to the circuit board and the optical component 100a separately. The circuit board is configured to receive and send an instruction. The photoelectric conversion module is configured to convert a received electrical signal into an optical signal, and send the converted optical signal to the optical component 100a. The optical fiber connector 100b is connected to the optical fiber 1b. The optical component 100a and the optical fiber connector 100b are separately connected to the adapter 200, to implement interconnection between the optical transceiver module 1a and the optical fiber 1b, thereby implementing optical signal adaptation between the optical transceiver module 1a and the optical fiber 1b.

The following describes in detail a mechanical connection manner and a signal connection manner between the optical transceiver module 1a and the optical component 100a in this application with reference to the accompanying drawings.

FIG. 1(b) is a side view of the optical component 100a according to some embodiments of this application. FIG. 1(c) is a sectional view along an M-M section in FIG. 1(b). With reference to FIG. 1(b) and FIG. 1(c), it can be learned that in some embodiments of this application, the optical component 100a includes an optical component base 110a, where the optical component base 110a has a first optical component end face 111a and a second optical component end face 112a that are disposed opposite to each other. An optical fiber hole 120a is provided in the optical component 100a, the optical fiber hole 120a communicates the first optical component end face 111a with the second optical component end face 112a, and the optical fiber hole 120a is configured to insert a fiber core of an optical fiber in the optical transceiver module 1a.

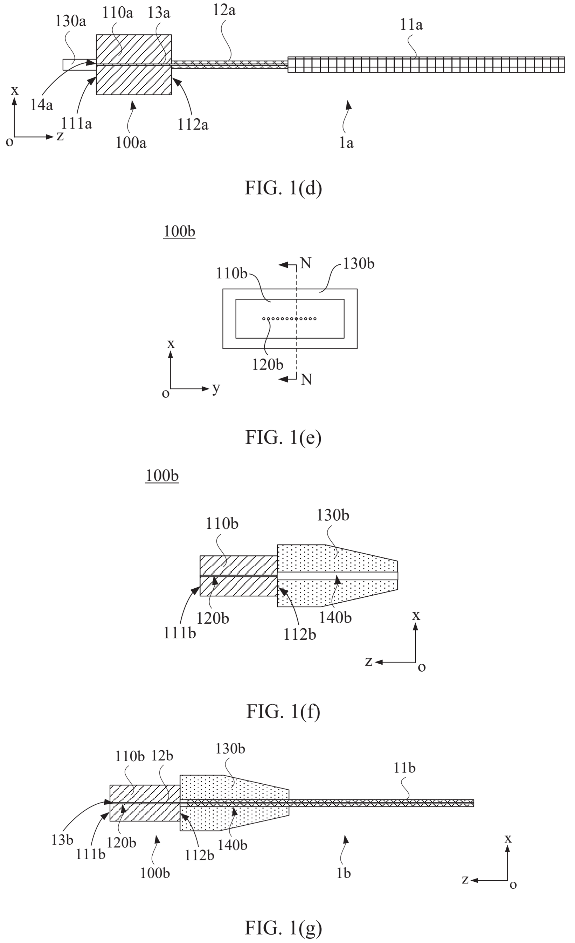

FIG. 1(d) is a sectional view of an optical component 100a and the optical transceiver module 1a in an assembled state along the section in FIG. 1(b). As shown in FIG. 1(d), the optical transceiver module 1a includes a processing module 11a and an optical fiber 12a for a signal connection, and the optical fiber 12a is in a signal connection to the processing module 11a. With reference to FIG. 1(c) and FIG. 1(d), it is not difficult to find that a fiber core 13a of the optical fiber 12a is inserted into the optical fiber hole 120a. In addition, an end face of the fiber core 13a is flush with an end face 111a of the first optical component. It may be understood that, in an application scenario of the optical transceiver module 1a and the optical component 100a, the optical fiber 12a is middleware configured to implement a mechanical connection and an electrical connection between the processing module 11a and the optical component 100a.

With continued reference to FIG. 1(b) to FIG. 1(d), in some embodiments of this application, the optical component 100a further includes a positioning post 130a, and the positioning post 130a is disposed on the first optical component end face 111a of the optical component base 110a. In the assembled state, the positioning post 130a can be inserted into a positioning hole in the adapter 200. Based on this, the foregoing structure can implement positioning of the optical component 100a and the optical transceiver module 1a relative to the adapter 200. The positioning post 130a and the optical component base 110a may be made of a same material, and the positioning post 130a and the optical component base 110a may be integrally formed. This is not specifically limited in this application.

In some implementations, the processing module 11a may be a chip, or may be a circuit board integrated with a chip. This is not specifically limited in this application.

In some implementations, the material of the optical component 100a is a metal material. For example, the material of the optical component 100a may be stainless steel, aluminum alloy, or the like. This is not specifically limited in this application.

The following describes in detail a mechanical connection manner and a signal connection manner between the optical fiber 1b and the optical fiber connector 100b in this application with reference to the accompanying drawings.

FIG. 1(e) is a side view of the optical fiber connector 100b according to some embodiments of this application. FIG. 1(f) is a sectional view along an N-N section in FIG. 1(e). With reference to FIG. 1(e) and FIG. 1(f), it can be learned that in some embodiments of this application, the optical fiber connector 100b includes a ferrule 110b, where the ferrule 110b has a first ferrule end face 111b and a second ferrule end face 112b that are disposed opposite to each other. An optical fiber hole 120b is provided in the ferrule 110b, the optical fiber hole 120b communicates the first ferrule end face 111b with the second ferrule end face 112b, and the optical fiber hole 120b is configured to insert a fiber core of the optical fiber 1b. In addition, the optical fiber connector 100b further includes a protective component 130b, and the protective component 130b has a first protective end face 131b and a second protective end face 132b that are disposed opposite to each other. The first protective end face 131b of the protective component 130b is connected to the second ferrule end face 112b of the ferrule 110b. A protective hole 140b is further provided in the protective component 130b, and the protective hole 140b communicates the first protective end face 131b with the second protective end face 132b. The protective hole 140b can clamp a protective jacket of the optical fiber 1b to enhance stability of the connection between the optical fiber 1b and the optical fiber connector 100b.

FIG. 1(g) is a sectional view of the optical fiber connector 100b and the optical fiber 1b in the assembled state along the N-N section in FIG. 1(e). As shown in FIG. 1(g), the optical fiber 1b includes an optical fiber body 11b and a fiber core 12b, and the fiber core 12b extends from the fiber core in the optical fiber body 11b. With reference to FIG. 1(f) and FIG. 1(g), it is not difficult to find that the optical fiber body 11b is installed in the protective hole 140b in the protective component 130b, and the fiber core 12b is inserted into the optical fiber hole 120b in the ferrule 110b. An end face of the fiber core 12b is flush with the first ferrule end face 111b of the ferrule 110b.

It may be understood that, in the assembled state, an outer circumferential surface of the ferrule 110b may be adapted to a mounting hole in the adapter 200 as a limiting feature.

In some implementations, the ferrule 110b may be made of a plastic material. For example, the material of the ferrule 110b may be polyethylene, polypropylene, polyvinyl chloride, polystyrene, or the like. This is not specifically limited in this application.

After the mechanical connection manner and the signal connection manner between the optical transceiver module 1a and the optical component 100a and the mechanical connection manner and the signal connection manner between the optical fiber 1b and the optical fiber connector 100b are separately described, the following describes in detail mechanical connection manners and signal connection manners between the optical transceiver module 1a, the optical component 100a, the optical fiber 1b, the optical fiber connector 100b, and the adapter 200 in this application with reference to the accompanying drawings.

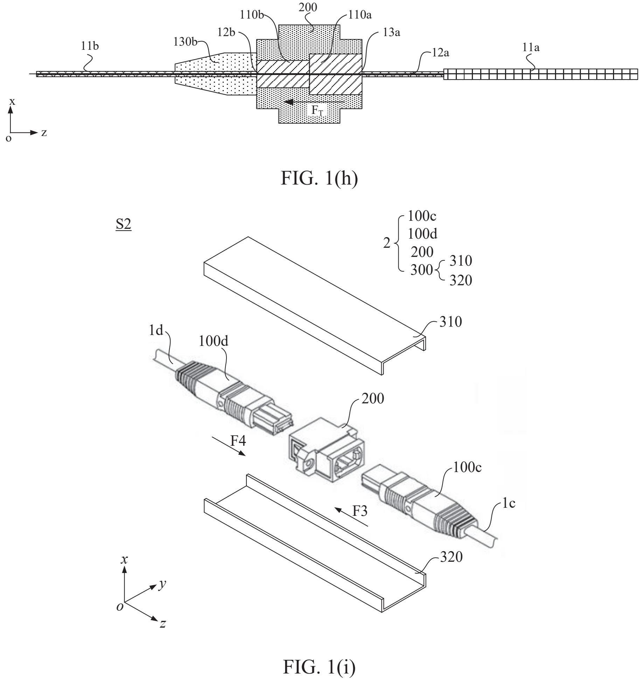

FIG. 1(h) is a sectional view of the optical transceiver module 1a, the optical component 100a, the optical fiber 1b, the optical fiber connector 100b, and the adapter 200 along the N-N section in FIG. 1(e) according to some embodiments of this application.

As shown in FIG. 1(h), in some embodiments of this application, the adapter 200 includes an adapter body 210, and the adapter body 210 includes a first mating surface 211 and a second mating surface 212 that are disposed opposite to each other. In the adapter body 210, a first mating hole 220 is formed in the first mating surface 211, a second mating hole 230 is formed in the second mating surface 212, and the first mating hole 220 communicates with the second mating hole 230.

With reference to FIG. 1(b) to FIG. 1(h), it can be learned that, in the assembled state, in some embodiments of this application, the optical component base 110a is inserted into the first mating hole 220 in the adapter body 210, and the ferrule 110b is inserted into the second mating hole 230 in the adapter body 210. In addition, the first optical component end face 111a of the optical component base 110a abuts against the first ferrule end face 111b of the ferrule 110b, and the end face of the fiber core 13a abuts against the end face of the fiber core 12b.

In some implementations, a central axis of the fiber core 13a coincides with a central axis of the fiber core 12b.

In some application scenarios, an optical signal is transmitted from the optical transceiver module 1a to the optical fiber 1b. For ease of description, an extension direction of the fiber core 13a and a direction reverse to an extension direction of the fiber core 12b are defined as a transmission direction FT, and the central axis of the fiber core 13a and the central axis of the fiber core 12b are defined as a transmission axis AT.

It may be understood that, in some other application scenarios, an optical signal may alternatively be transmitted from the optical fiber 1b to the optical transceiver module 1a. A principle in these application scenarios is similar to that in the foregoing application scenarios, and details are not described herein.

The optical signal adapter solution provided in this application can be further applied to an application scenario in which an optical fiber is connected to an optical fiber. The following provides brief descriptions with reference to the accompanying drawings. In the field of optical communication, securing and interconnection of two optical fibers are generally achieved through cooperation of an optical fiber connector and an optical fiber adapter. FIG. 1(i) is a diagram of an optical signal adapter system S2 in some application scenarios of this application. As shown in FIG. 1(i), the optical signal adapter system S2 includes a first optical fiber 1c, a second optical fiber 1d, and an optical signal adapter assembly 2. The first optical fiber 1c and the second optical fiber 1d are interconnected by the optical signal adapter assembly 2, so that optical signal transmission is implemented between the first optical fiber 1c and the second optical fiber 1d. The optical signal adapter assembly 2 includes an optical fiber connector 100c, an optical fiber connector 100d, an adapter 200, and a housing 300. The optical fiber connector 100c is connected to the first optical fiber 1c, the optical fiber connector 100d is connected to the second optical fiber 1d, and the optical fiber connector 100c and the optical fiber connector 100d are separately connected to the adapter 200, to implement interconnection between the first optical fiber 1c and the second optical fiber 1d, thereby implementing optical signal adaptation between the first optical fiber 1c and the second optical fiber 1d.

It may be understood that, for a mechanical connection manner and an electrical connection manner between the first optical fiber 1c and the optical fiber connector 100c in FIG. 1(i), and a mechanical connection manner and an electrical connection manner between the second optical fiber 1d and the optical fiber connector 100d, refer to the mechanical connection manner and the electrical connection manner between the optical fiber 1b and the optical fiber connector 100b in FIG. 1(a) to FIG. 1(h). Details are not described herein again.

In some embodiments of this application, there are various connectors in this application. The connector in this application may be at least one of a multipurpose push-on/pull-off (multipurpose push-on/pull-off, MPO) connector, a lucent connector (lucent connector, LC), a standard connector (standard connector, SC), and an active optical cable (active optical cable, AOC) connector. This is not specifically limited in this application. The adapter in this application is an adapter module adapted to the connector. Correspondingly, the adapter may be at least one of an MPO adapter, an LC adapter, an SC adapter, and an AOC adapter. In some implementations, the adapter may be an adapter assembly, where the adapter assembly is an adapter two sides of which correspond to different types of connectors. In some other alternative implementations, the adapter may be a coupler, where the coupler is an adapter two sides of which correspond to a same type of connectors. For example, a first adapter module is a male MPO connector, a second adapter module is a female MPO connector, and the adapter module is a corresponding MPO adapter. The male MPO connector and the female MPO connector interconnect fiber cores of two optical fibers through the MPO adapter.

The following describes the optical signal adapter solution in this application in detail with reference to the accompanying drawings by using one side of the foregoing optical adapter system as an example.

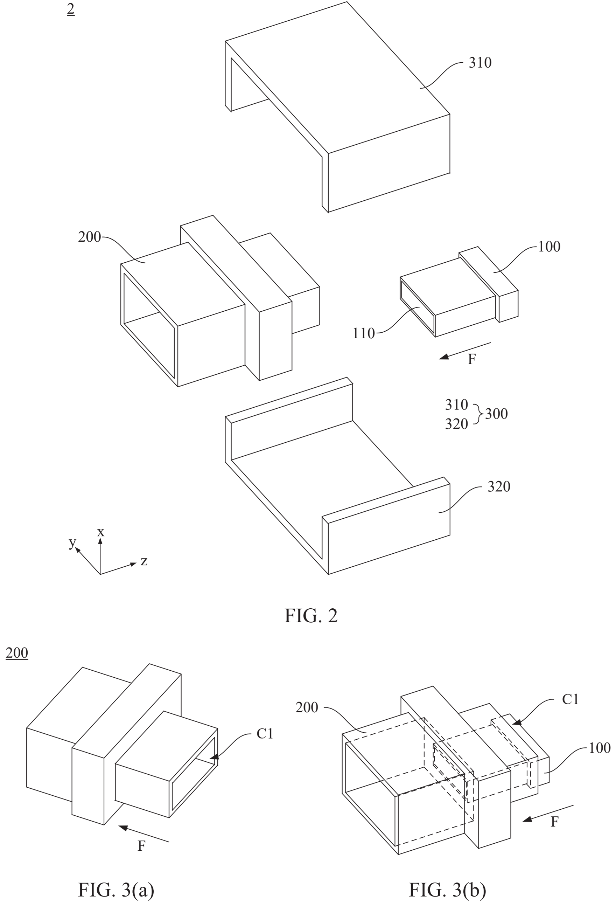

FIG. 2 is an exploded view of the optical signal adapter assembly 2 according to some embodiments of this application. It may be understood that the optical signal adapter assembly 2 in FIG. 2 is configured to connect a first optical module to a second optical module, to implement optical signal transmission between the first optical module (for example, the optical transceiver module 1a in FIG. 1(a)) and the second optical module (for example, the optical fiber 1b in FIG. 1(a)). The first optical module may be an optical fiber or an optical transceiver module. The second optical module may be an optical fiber or an optical transceiver module. This is not specifically limited in this application. As shown in FIG. 2, the optical signal adapter assembly 2 includes a connector module 100, an adapter 200, and a housing 300, and the connector module 100 includes a connector core 110. The connector core 110 is configured to establish an optical signal connection to the first optical module. It may be understood that the optical signal connection between the connector core 110 and the first optical module means that the connector core 110 can transmit an optical signal from the first optical module. For example, an optical signal structure that can transmit an optical signal is disposed in the connector core 110, and the connector core 110 can transmit the optical signal by using the optical signal structure. For another example, a channel for extending the first optical module is disposed in the connector core 110, and the first optical module passing through the connector core 110 transmits the optical signal. This is not specifically limited in this application.

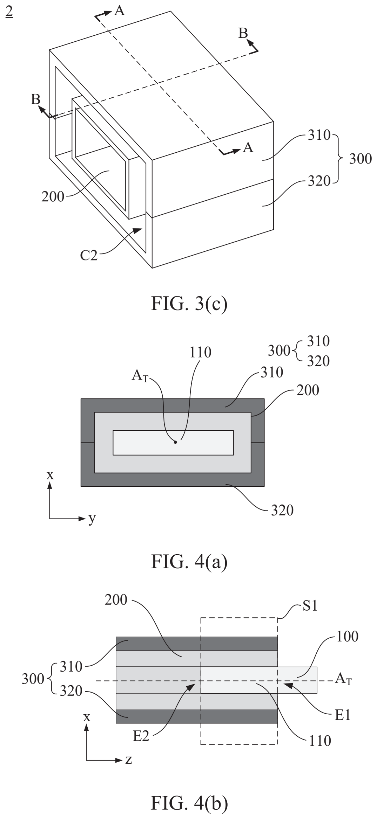

FIG. 3(a) is a three-dimensional view of the adapter 200 from another angle according to some embodiments of this application. FIG. 3(b) is a perspective view after the connector module 100 and the adapter 200 are assembled according to some embodiments of this application. FIG. 3(c) is a three-dimensional view after the connector module 100, the adapter 200, and the housing 300 are assembled according to some embodiments of this application. FIG. 3(c) shows an A-A section and a B-B section that pass through the connector module 100, the adapter 200, and the housing 300.

With reference to FIG. 2 to FIG. 3(c), it can be learned that a slot C1 for inserting the connector core 110 is provided in the adapter 200. In an assembled state, the connector core 110 in the connector module 100 is inserted into the slot C1 in the adapter 200 along an insertion direction F, where the insertion direction is a direction in which the connector core 110 is inserted into the slot C1 in the adapter 200. An installation channel C2 is formed in the housing 300, and the connector 100 and the adapter 200 are installed in the installation channel C2.

In some implementations, the optical module may be an optical transceiver module, the connector module 100 may be an optical component, and the connector core 110 is a metal structure that is in the connector module 100 and that is configured to establish an optical signal connection to another structure in the optical transceiver module.

In some other alternative implementations, the optical module may be an optical fiber, the connector module 100 may be a connector, and the connector core 110 is a ferrule that is in the connector module 100 and that is configured to establish an optical signal connection to the optical fiber. An optical fiber hole (not shown in the figure) is provided in the ferrule, and the optical fiber hole extends along the insertion direction F and penetrates through the ferrule. The optical fiber is installed in the optical fiber hole, and extends out of the optical fiber hole in a direction reverse to the insertion direction F.

FIG. 4(a) is a sectional view of the optical signal adapter assembly 2 along the A-A section in FIG. 3(c) according to some embodiments of this application. FIG. 4(b) is a sectional view of the optical signal adapter assembly 2 along the B-B section in FIG. 3(c) according to some embodiments of this application. With reference to FIG. 4(a) and FIG. 4(b), it can be learned that, for ease of the following description, a structure including the connector module 100, the adapter 200, and the housing 300 is defined as a waveguide structure (corresponding to an area S1 in FIG. 4(b)) in the optical signal adapter assembly 2, where the area S1 may also be referred to as an insertion area, one end of the waveguide structure close to the optical module is defined as a first end E1, and one end of the waveguide structure away from the optical component is defined as a second end E2.

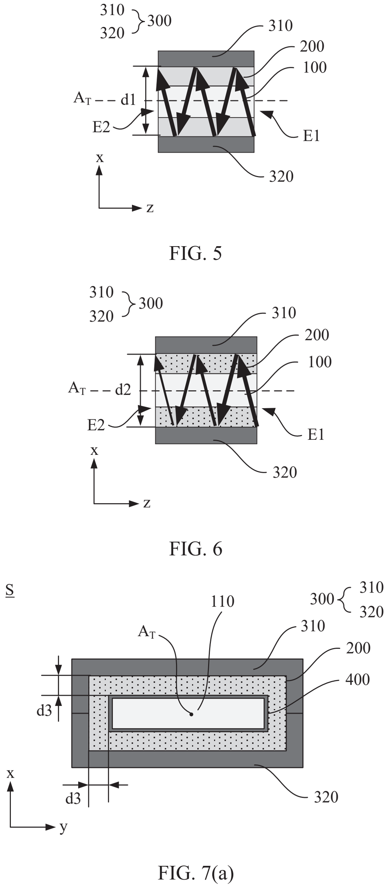

In some embodiments of this application, the connector core 110 is made of a plastic material, the adapter 200 is also made of a plastic material, and the housing 300 is made of a conductive material. FIG. 5 is a partial enlarged view of the area S1 in FIG. 4(b) according to some embodiments of this application, where a transmission path of electromagnetic waves of an electronic device in the waveguide structure in the optical signal adapter assembly 2 is illustrated. In this application, the electromagnetic waves of the electronic device are electromagnetic waves that cause electromagnetic interference to another device. The electromagnetic waves in this application may come from another electronic component in the electronic device (for example, a chip or a circuit board in the electronic device). This is not specifically limited in this application.

In some embodiments of this application, as shown in FIG. 5, because the connector core 110 and the adapter 200 are made of plastic materials, and the housing 300 is made of a conductive material, a waveguide structure similarly forms a rectangular waveguide. In addition, after the electromagnetic waves enter from an end face of the adapter 200 at the first end E1 of the waveguide structure, the electromagnetic waves undergo total reflection within the rectangular waveguide and are transmitted along a direction of an arrow in FIG. 5 to the second end E2 of the waveguide structure.

With reference to FIG. 5, it is not difficult to find that, in the optical signal adapter assembly 2, although optical signal adaptation between two optical modules can be implemented by properly designing structures and materials of the connector core 110, the adapter 200, and the housing 300, because the connector core 110 and the adapter 200 are made of plastic materials, a loss of electromagnetic waves is relatively small when the electromagnetic waves pass through the waveguide structure. Consequently, electromagnetic waves radiated from the electronic device are relatively strong and do not meet regulatory limit requirements.

To resolve the foregoing problem, in some technical solutions, a structural size of the adapter 200 may be reduced. Reducing an opening size of an optical port of the adapter 200 can shorten an electromagnetic radiation leakage path, thereby reducing external electromagnetic interference of the optical signal adapter assembly 2 and improving electromagnetic compatibility of the optical signal adapter assembly 2. The optical port of the adapter 200 is an outer contour of a cross-section of the adapter 200 that is perpendicular to the insertion direction F. The opening size of the optical port of the adapter 200 is an area enclosed by the outer contour of the cross-section.

In the optical signal adapter assembly 2, reducing the opening size of the optical port of the adapter 200 can reduce a cross-sectional size of the rectangular waveguide formed by the waveguide structure, that is, reduce a size of an electromagnetic radiation leakage gap, and increase a loss of high-frequency electromagnetic waves in the adapter 200, thereby reducing external electromagnetic interference of the electronic device and improving electromagnetic compatibility of the electronic device. However, constrained by optical fiber performance or standard requirements, the opening size of the optical port of the adapter 200 in the optical signal adapter assembly 2 cannot be fully reduced. Ultimately, a good shielding effect cannot be achieved in this solution.

To resolve the foregoing problem, in some other embodiments of this application, in the optical signal adapter assembly 2, a plastic base material of the adapter 200 is doped with a conductive filler and/or a magnetic filler, to improve a signal shielding effect of the adapter 200 against external electromagnetic waves. FIG. 6 is a partial enlarged view of the area S1 in FIG. 4(b) according to some other embodiments of this application, where the transmission path of the electromagnetic waves in the waveguide structure in the optical signal adapter assembly 2 is illustrated. In some embodiments of this application, as shown in FIG. 6, because the connector core 110 is made of a plastic material, and the adapter 200 is made of a plastic material doped with a conductive filler and/or a magnetic filler, and the housing 300 is made of a conductive material, the waveguide structure similarly forms a rectangular waveguide. In addition, after the external electromagnetic waves enter from an end face of the adapter 200 at the first end E1 of the waveguide structure, the external electromagnetic waves undergo total reflection within the rectangular waveguide and are transmitted along a direction of an arrow in FIG. 6 to the second end E2 of the waveguide structure. In addition, because conductive particles and/or magnetic particles are added to the adapter 200, a dielectric loss and a magnetic loss of the adapter 200 are increased, thereby improving electromagnetic shielding performance and interference resistance of the waveguide structure.

With reference to FIG. 6, it is not difficult to find that, in the optical signal adapter assembly 2, by properly designing structures and materials of the connector core 110 in the connector module 100, the adapter 200, and the housing 300, the signal shielding effect of the adapter 200 against the external electromagnetic waves can be improved. However, doping of the conductive filler and/or the magnetic filler in the adapter 200 reduces mechanical performance of the adapter 200. In addition, a doping percentage of the conductive filler and/or the magnetic filler is limited. As a result, the shielding effect of the adapter 200 is limited, and it is difficult to meet an application requirement of a current user for electromagnetic shielding of the optical signal adapter assembly 2.

To resolve the foregoing problem, in still some other embodiments of this application, in the optical signal adapter assembly 2, the connector core 110 is made of a plastic material, a plastic base material of the adapter 200 is doped with a conductive filler and/or a magnetic filler, the housing 300 is made of a conductive material, and a conductive layer 400 is additionally disposed between the connector core 110 and the adapter 200, to fully isolate the connector core 110 from the adapter 200. The adapter 200, the conductive layer 400, and the housing 300 form a concentric-square waveguide structure, and a medium in the concentric-square waveguide structure is a plastic material filled with a conductive filler and/or a magnetic filler.

With reference to FIG. 6, it can be learned that the conductive layer 400 encloses the connector core 110 around a transmission axis AT. The adapter 200 encloses the conductive layer 400 around the transmission axis AT. The housing 300 encloses the adapter 200 around the transmission axis AT. The conductive layer 400 is used as a first conductive layer, the adapter 200 is used as a dielectric layer, and the housing 300 is used as a second conductive layer to form a concentric-square waveguide structure. In other words, the concentric-square waveguide structure sequentially includes the connector core 110, the conductive layer 400, the adapter 200, and the housing 300 from inside to outside along a radial direction. The radial direction is perpendicular to the transmission axis.

Based on this, the foregoing waveguide structure is a lossy waveguide structure, and the transmission path of the electromagnetic waves is changed by using the housing 300 and the conductive layer 400, so that the transmission path of the electromagnetic waves falls as much as possible into an area in which the adapter 200 is located. In addition, by optimizing the material of the adapter 200, an electromagnetic wave loss caused by the adapter 200 is increased. Based on this, the foregoing waveguide structure can increase the electromagnetic wave loss and improve the shielding effect.

In some embodiments of this application, the conductive layer 400 is a film-like structure that rotates around the transmission axis. In some implementations, a thickness of the conductive layer 400 ranges from 1 µm to 500 µm. The thickness of the conductive layer 400 is a size of the conductive layer 400 in a direction perpendicular to the transmission axis, that is, a distance from a surface of one side that is of the conductive layer 400 and that faces toward the connector core 110 to a surface of one side that is of the conductive layer 400 and that faces toward the adapter 200, on one side of the transmission axis. For example, the thickness of the conductive layer 400 is any one of 1 µm, 10 µm, 20 µm, 30 µm, 40 µm, 50 µm, 100 µm, 150 µm, 200 µm, 250 µm, 300 µm, 350 µm, 400 µm, 450 µm, and 500 µm.

In some embodiments of this application, a thickness of the housing 300 is greater than 1 µm. The thickness of the housing 300 is a size of the housing 300 in a direction perpendicular to the transmission axis, that is, a distance from an outer side of the housing 300 to a surface of one side that is of the housing 300 and that faces toward the adapter 200, on one side of the transmission axis.

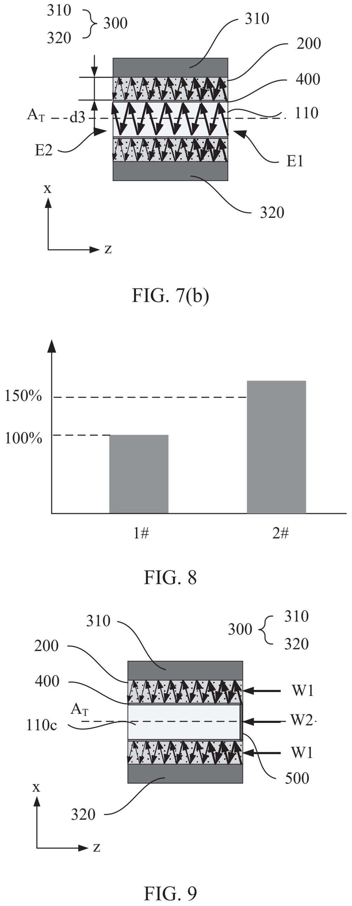

FIG. 7(a) is a sectional view of the optical signal adapter assembly 2 along the A-A section in FIG. 3(c) according to some other embodiments of this application. FIG. 7(b) is a partial enlarged view of the area S1 in FIG. 4(b) in some other embodiments of this application, where the transmission path of the electromagnetic waves in the waveguide structure is illustrated. In some embodiments of this application, as can be learned with reference to FIG. 7(a) and FIG. 7(b), the connector core 110 is made of a plastic material, the adapter 200 is made of a plastic material doped with a conductive filler and/or a magnetic filler, the housing 300 is made of a conductive material, and the conductive layer 400 is disposed between the connector core 110 and the adapter 200. The waveguide structure in the optical signal adapter assembly in this embodiment similarly forms a concentric-square waveguide. In addition, after the external electromagnetic waves enter from an end face of the adapter 200 at the first end of the waveguide structure, the external electromagnetic waves undergo total reflection within the rectangular waveguide and are transmitted along a direction of an arrow in FIG. 7(b) to the second end of the waveguide structure. A size of an electromagnetic radiation leakage gap of the concentric-square waveguide is relatively small. For example, d3 in FIG. 7(a) and FIG. 7(b) is less than d1 in FIG. 5 and d2 in FIG. 6. In addition, because conductive particles and/or magnetic particles are added to the adapter 200, conductivity and/or magnetic permeability of the adapter 200 can be increased, thereby improving electromagnetic shielding performance and interference resistance of the waveguide structure.

With reference to FIG. 7(a) and FIG. 7(b), it is not difficult to find that, in the optical signal adapter assembly 2, the adapter 200 is designed as a composite material having an electrical loss function and/or a magnetic loss function, and is used together with the housing 300 and the conductive layer 400 to form a concentric-square high-loss composite waveguide structure, thereby reducing leakage of the external electromagnetic waves from the optical port of the optical signal adapter assembly 2 and improving the shielding effect by more than 5 dB.

With reference to the shielding effect, the following describes shielding performance of the optical signal adapter assembly 2 corresponding to FIG. 7(a) and FIG. 7(b). FIG. 8 is a diagram illustrating a shielding effect of an optical signal adapter solution applicable to an MPO connector according to some embodiments of this application. A longitudinal axis represents a shielding effect percentage, 1# represents an optical signal adapter solution in which a material applicable to the MPO adapter includes a conductive filler and/or a magnetic filler but does not include the conductive layer 400, and 2# represents an optical signal adapter solution in which a material applicable to the MPO adapter includes a conductive filler and/or a magnetic filler and includes the conductive layer 400. As shown in FIG. 8, a shielding effect of the optical signal adapter solution corresponding to the 2# structure is improved by more than 50% compared with that of the optical signal adapter solution corresponding to the 1# structure. The shielding effect of the optical signal adapter solution with the concentric-square lossy waveguide structure in this application is better. Based on this, compared with other optical signal adapter solutions, the optical signal adapter solution in this application achieves significant noise reduction, to ensure that the optical signal adapter assembly 2 meets a test standard, and reduce design difficulty of the optical signal adapter assembly 2.

To further improve a shielding effect of the optical signal adapter assembly 2, conductive layers are additionally disposed at two ends of the connector core 110, to further adjust the transmission path of the electromagnetic waves in the optical signal adapter assembly 2. FIG. 9 is a partial enlarged view of the area S1 in FIG. 4(b) according to still some other embodiments of this application. As shown in FIG. 9, in still some other embodiments of this application, in the optical signal adapter assembly 2, the connector core 110 is made of a plastic material, and the connector core 110 has a first connection end connected to an optical module and a second connection end away from the first connection end. A conductive layer 500 is additionally disposed at the first connection end and/or the second connection end of the connector core 110. The adapter 200 is made of a plastic material doped with a conductive filler and/or a magnetic filler, the housing 300 is made of a conductive material, and a conductive layer 400 is additionally disposed between the connector core 110 and the adapter 200.

In the optical signal adapter assembly 2, the conductive layer 500 is additionally disposed at the first connection end and/or the second connection end of the connector core 110, so that the electromagnetic waves can be prevented from being radiated directly from the connector core 110. Based on this, the foregoing waveguide structure can further optimize the transmission path of the electromagnetic waves, so that as many electromagnetic waves as possible fall into the area in which the adapter 200 is located, thereby further increasing the electromagnetic wave loss caused by the adapter 200. Based on this, the foregoing waveguide structure can further increase the electromagnetic wave loss, and therefore can further improve the shielding effect of the optical signal adapter assembly 2.

In some embodiments of this application, the conductive layer 500 is a film-like structure that is perpendicular to the transmission axis. In some implementations, a thickness of the conductive layer 500 ranges from 1 µm to 500 µm. The thickness of the conductive layer 500 is a size of the conductive layer 500 in a direction of the transmission axis. For example, the thickness of the conductive layer 400 is any one of 1 µm, 10 µm, 20 µm, 30 µm, 40 µm, 50 µm, 100 µm, 150 µm, 200 µm, 250 µm, 300 µm, 350 µm, 400 µm, 450 µm, and 500 µm.

The following describes in detail the optical signal adapter solution in this application with reference to a specific scenario.

### Application scenario 1

The following describes in detail an optical signal adapter solution in this application with reference to the accompanying drawings by using optical signal adaptation between a first optical fiber 1c and a second optical fiber 1d as an example.

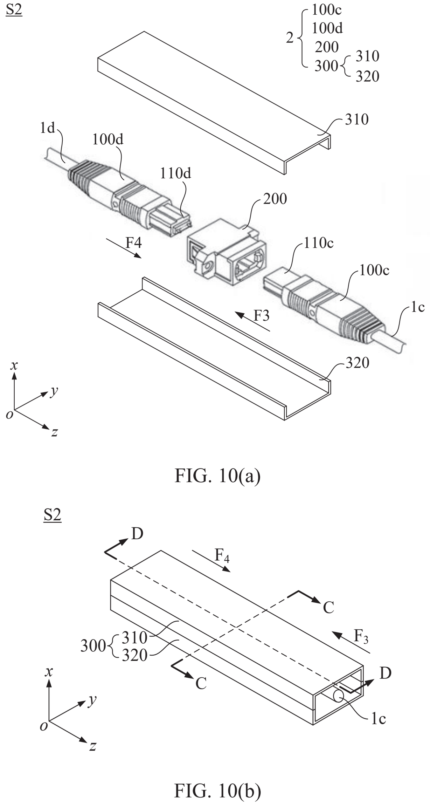

FIG. 10(a) is an exploded view of an optical signal adapter system S2 according to some embodiments of this application. FIG. 10(b) is a three-dimensional view of the optical signal adapter system S2 in FIG. 10(a).

With reference to FIG. 10(a) and FIG. 10(b), it can be learned that in some embodiments of this application, the optical signal adapter system S2 includes a first optical fiber 1c, a second optical fiber 1d, and an optical signal adapter assembly 2, where the optical signal adapter assembly 2 is configured to implement optical signal adaptation between the first optical fiber 1c and the second optical fiber 1d. The optical signal adapter assembly 2 includes a first connector 100c, a second connector 100d, an adapter 200, and a housing 300.

The first connector 100c includes a first ferrule 110c, a first optical fiber hole (not shown in the figure) is provided in the first ferrule 110c, and the first optical fiber hole extends along a first insertion direction F3 of the first ferrule 110c and penetrates through the first ferrule 110c. The first insertion direction F3 is a direction in which the first ferrule 110c is inserted into the adapter 200. The first optical fiber 1c is installed in the first optical fiber hole, and the first optical fiber 1c extends out of the first optical fiber hole in the first ferrule 110c in a direction reverse to the first insertion direction F3.

Similarly, the second connector 100d includes a second ferrule 110d, a second optical fiber hole (not shown in the figure) is provided in the second ferrule 110d, and the second optical fiber hole extends along a second insertion direction F4 of the second ferrule 110d and penetrates through the second ferrule 110d. The second insertion direction F4 is a direction in which the second ferrule 110d is inserted into the adapter 200. The second optical fiber 1d is installed in the second optical fiber hole, and the second optical fiber 1d extends out of the second optical fiber hole in the second ferrule 110d in a direction reverse to the second insertion direction F4.

A first slot (not shown) for inserting the first ferrule 110c and a second slot (not shown) for inserting the second ferrule 110d are provided in the adapter 200, and the first slot communicates with the second slot.

An installation channel (not shown in the figure) is formed in the housing 300. The first connector 100c, the second connector 100d, and the adapter 200 are installed in the installation channel. In addition, the first optical fiber 1c extends out of the housing 300 along the installation channel from the first connector 100c, and the second optical fiber 1d extends out of the housing 300 along the installation channel from the second connector 100d.

In some embodiments of this application, as shown in FIG. 10(a) and FIG. 10(b), the housing 300 may include a first housing 310 and a second housing 320. The first housing 310 and the second housing 320 together form the installation channel. In the optical signal adapter system S2, the housing 100 uses a split design, to facilitate installation of an internal component in an inner cavity and reduce design difficulty and assembly difficulty of the optical signal adapter system S2. In some other embodiments of this application, the housing 300 may alternatively be an integrally formed structure, and the installation channel penetrates through the housing 300. In the optical signal adapter system S2, there is only one housing 300, which reduces a quantity of components in the system and improves mechanical performance. For ease of understanding, the following uses the housing 300 including the first housing 310 and the second housing 320 as an example for description.

Because a principle of an optical signal adapter solution between the adapter 200 and the first connector 100c is similar to a principle of an optical signal adapter solution between the adapter 200 and the second connector 100d, the optical signal adapter solution between the adapter 200 and the first connector 100c is used as an example for description herein.

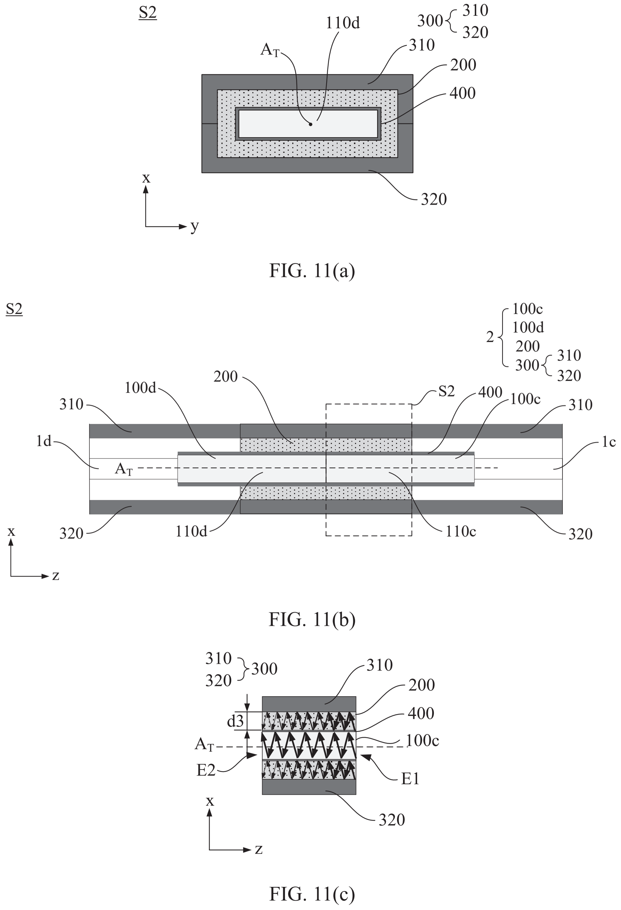

FIG. 11(a) is a sectional view of the optical signal adapter assembly 2 along a C-C section in FIG. 10(b) according to some embodiments of this application. FIG. 11(b) is a sectional view of the optical signal adapter assembly 2 along a D-D section in FIG. 10(b) according to some embodiments of this application.

With reference to FIG. 11(a) and FIG. 11(b), it can be learned that in some embodiments of this application, the optical signal adapter assembly 2 further includes a conductive layer 400. A first optical fiber hole extending along the first insertion direction F3 is provided in the first connector core 110c, and the first optical fiber 1c passes through the first optical fiber hole. The conductive layer 400 encloses the first connector core 110c around a first axis, where the first axis is parallel to the first insertion direction F3. A material of the adapter 200 includes a conductive filler and/or a magnetic filler, and the adapter 200 encloses the conductive layer 400 around the first axis. The housing 300 encloses the adapter 200 around the first axis. The housing 300 is made of a conductive material, for example, a metal material.

In some embodiments of this application, no gap exists between the housing 300 and the adapter 200, between the adapter 200 and the conductive layer 400, and between the conductive layer 400 and the first connector core 110c. In other words, opposite surfaces of these components abut against or are in contact with each other. This is not specifically limited in this application.

In some other embodiments of this application, a gap is formed in at least one of the following pairs: the housing 300 and the adapter 200, the adapter 200 and the conductive layer 400, and the conductive layer 400 and the first connector core 110c. It may be understood that, under a condition that relative fixation of the housing 300, the adapter 200, the conductive layer 400, and the first connector core 110c is ensured, any assembly solution of the housing 300, the adapter 200, the conductive layer 400, and the first connector core 110c falls within the protection scope of this application. This is not specifically limited in this application.

It may be understood that FIG. 11(a) and FIG. 11(b) are merely diagrams of contours of components in the optical signal adapter system S2 in this application, and do not represent actual contours of the components in the optical signal adapter system S2. Other contours of the components designed based on design requirements also fall within the protection scope of this application. This is not specifically limited in this application.

FIG. 11(c) is a partial enlarged view of an area S2 in FIG. 11(b) according to some embodiments of this application, where a transmission path of electromagnetic waves in a waveguide structure is illustrated. In some embodiments of this application, as shown in FIG. 11(c), the first connector core 110c in the first connector 100c is made of a plastic material, the adapter 200 is made of a plastic material doped with a conductive filler and/or a magnetic filler, the housing 300 is made of a conductive material, and the conductive layer 400 is disposed between the first connector core 110c in the first connector 100c and the first adapter 200. The waveguide structure in the optical signal adapter assembly 2 in this embodiment similarly forms a concentric-square waveguide. In addition, after external electromagnetic waves enter from an end face of the adapter 200 at a first end E1 of the waveguide structure, the external electromagnetic waves undergo total reflection within the rectangular waveguide and are transmitted along a direction of an arrow in FIG. 11(c) to a second end E2 of the waveguide structure. A size of an electromagnetic radiation leakage gap of the concentric-square waveguide is relatively small. In addition, because conductive particles and/or magnetic particles are added to the adapter 200, conductivity and/or magnetic permeability of the adapter 200 can be increased, thereby improving electromagnetic shielding performance and interference resistance of the waveguide structure, that is, improving electromagnetic shielding performance and interference resistance of the optical signal adapter system S2.

The following briefly describes the material of the adapter 200.

In some embodiments of this application, the conductive filler includes but is not limited to at least one of a carbon fiber, a nickel-coated carbon fiber, a metal conductive particle, a metal conductive fiber, carbon black, graphite, and a carbon nanotube.

In some embodiments of this application, the magnetic filler includes but is not limited to at least one of ferrite, iron powder, nickel-iron powder, nickel-zinc ferrite, ferric hydroxide, and magnetic ceramics.

In some embodiments of this application, a mass doping percentage of the conductive filler and/or the magnetic filler ranges from 0.5% to 40%. It may be understood that, in this application, the mass doping percentage of the conductive filler and/or the magnetic filler is a percentage of an accumulated weight of the conductive filler and/or the magnetic filler to a total mass of the adapter 200. The total weight of the adapter 200 is a sum of masses of the conductive filler and/or the magnetic filler and a plastic base material.

In some implementations, in the adapter 200, the mass doping percentage range of the conductive filler and/or the magnetic filler may be any one of 0.5%, 1%, 2%, 3%, 4%, 5%, 6%, 7%, 8%, 9%, 10%, 12.5%, 15%, 17.5%, 20%, 22.5%, 25%, 27.5%, 30%, 32.5%, 35%, 37.5%, and 40%.

It may be understood that, in the adapter 200, the mass doping percentage of the conductive filler and/or the magnetic filler is merely a part of implementations shown. A mass doping percentage of the conductive filler and/or the magnetic filler in a specific application scenario needs to be determined based on an actual situation. This is not specifically limited in this application.

In some embodiments of this application, both the conductive filler and the magnetic filler can be used as additives to improve electromagnetic performance of plastic. A manner of doping the plastic base material with the conductive filler and a manner of doping the plastic base material with the magnetic filler are basically the same. In the following description, the manner of doping the plastic base material with the conductive filler is used as an example.

In some implementations, the conductive filler and the plastic base material are directly mixed based on a preset mass doping percentage.

In some other alternative implementations, the conductive filler and the plastic base material are mixed by using a surface processing method based on a preset mass doping percentage. For example, the conductive filler includes an electronic-grade filler, such as nano-silver or a carbon nanotube. Surface modification processing (for example, carboxylation and silanization) is performed on a surface of the conductive filler, and then the surface-modified conductive filler and the plastic base material are mixed based on the preset mass doping percentage. The doping method enables the conductive filler to be more compatible with the plastic base material, and enhances dispersion performance of the conductive filler in the plastic base material.

It should be noted that different filler doping manners are applicable to different filler types and electromagnetic performance indicators to be achieved, and need to be adaptively selected. In addition, strict control over a mixing ratio and process parameters during doping can ensure that a final composite material meets a specified electromagnetic performance requirement.

After the material of the adapter 200 is described, the following briefly describes a specific implementation solution of the housing 300.

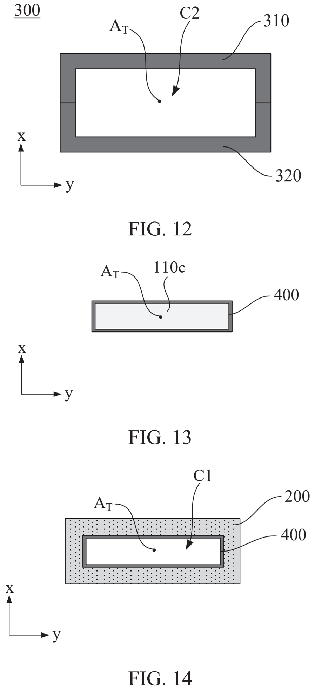

FIG. 12 is a diagram of the housing 300 according to some embodiments of this application. As shown in FIG. 12, an installation channel C2 that penetrates through the housing along an insertion direction is formed in the housing 300.

After the specific implementation solution of the housing 300 in the optical signal adapter system S2 is described, the following describes several arrangement solutions of the conductive layer 400 in detail with reference to the accompanying drawings.

In some embodiments of this application, the conductive layer 400 is formed on one of two opposite surfaces of the first ferrule 110c and the adapter 200. FIG. 13 is a diagram of the conductive layer 400 formed on the first ferrule 110c according to some embodiments of this application. As shown in FIG. 13, the conductive layer 400 is formed on a surface that is of the first ferrule 110c and that faces toward the adapter 200. FIG. 14 is a diagram of the conductive layer 400 formed on the adapter 200 according to some embodiments of this application. As shown in FIG. 14, the conductive layer 400 is formed on a surface that is of the adapter 200 and that faces toward the first ferrule 110c.

In some embodiments of this application, the conductive layer 400 includes a first conductive sublayer 410 and a second conductive sublayer 420. In addition, the first conductive sublayer 410 and the second conductive sublayer 420 cooperate with each other to enclose the first ferrule 110c around the first axis.

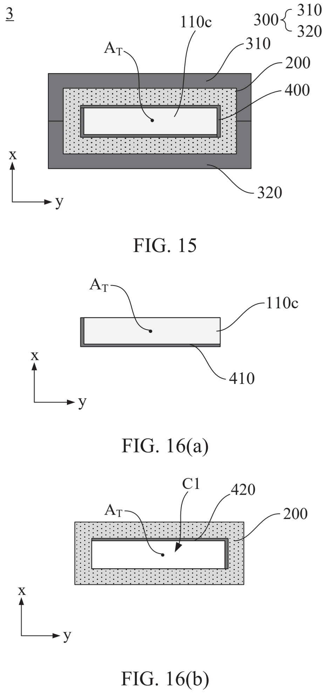

FIG. 15 is a sectional view of the optical signal adapter assembly 2 along the C-C section in FIG. 10(b) according to some other embodiments of this application. FIG. 16(a) is a diagram of the first conductive sublayer 410 formed on the ferrule 110c according to some other embodiments of this application. FIG. 16(b) is a diagram of the second conductive sublayer 420 formed on the adapter 200 according to some other embodiments of this application. In some embodiments of this application, with reference to FIG. 15 to FIG. 16(b), it can be learned that the first conductive sublayer 410 and the second conductive sublayer 420 cooperate with each other to enclose the first ferrule 110c around the first axis. The first conductive sublayer 410 is formed on a surface that is of the first ferrule 110c and that faces toward the adapter 200, and the second conductive sublayer 420 is formed on a surface that is of the adapter 200 and that faces toward the first ferrule 110c. Orthogonal projections of the first conductive sublayer 410 and the second conductive sublayer 420 on the surface that is of the first ferrule 110c and that faces toward the adapter 200 do not overlap each other at least partially. An orthogonal projection is a projection of a part along a normal direction of a projection surface. It should be noted that when projection surfaces are not in a same plane, normal directions of the projection surfaces that are not in the same plane are changed. This is not described again below.

It may be understood that structures of the first conductive sublayer 410 and the second conductive sublayer 420 in FIG. 16(a) and FIG. 16(b) are merely some examples in the implementations of this application. The first conductive sublayer 410 and the second conductive sublayer 420 in other forms also fall within the protection scope of this application. Details are not described herein.

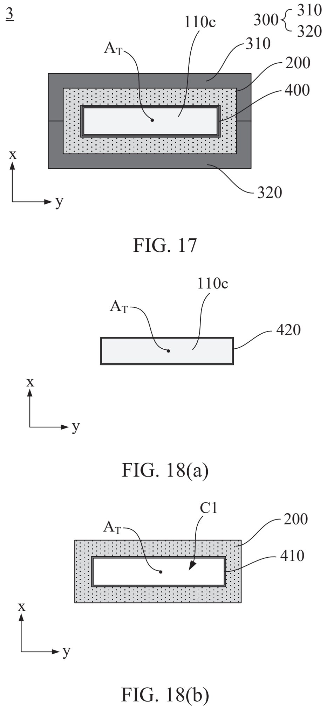

FIG. 17 is a sectional view of the optical signal adapter assembly 2 along the C-C section in FIG. 10(b) according to some other embodiments of this application. FIG. 18(a) is a diagram of the first conductive sublayer 410 formed on the ferrule 110c according to some other embodiments of this application. FIG. 18(b) is a diagram of the second conductive sublayer 420 formed on the adapter 200 according to some other embodiments of this application. In some embodiments of this application, with reference to FIG. 17 to FIG. 18(b), it can be learned that the first conductive sublayer 410 is formed on a surface that is of the first ferrule 110c and that faces toward the adapter 200, and that the second conductive sublayer 420 is formed on a surface that is of the adapter 200 and that faces toward the first ferrule 110c. Orthogonal projections of the first conductive sublayer 410 and the second conductive sublayer 420 on the surface that is of the first ferrule 110c and that faces toward the adapter 200 overlap each other at least partially.

It may be understood that structures of the first conductive sublayer 410 and the second conductive sublayer 420 in FIG. 18(a) and FIG. 18(b) are merely some examples in the implementations of this application. The first conductive sublayer 410 and the second conductive sublayer 420 in other forms also fall within the protection scope of this application. Details are not described herein.

After the arrangement solutions of the conductive layer 400 are described, the following briefly describes a specific formation manner of the conductive layer 400.

In some embodiments of this application, the conductive layer 400 may include a metal film layer. The metal film layer may include at least one of an aluminum film layer, an iron film layer, a copper film layer, and a gold film layer. In the optical signal adapter system S2, the conductive layer 400 is a metal film layer with good conductivity, stability, and oxidation resistance, and is applicable to fields of electronic components, optical components, and the like.

In some embodiments of this application, when the conductive layer 400 is a metal film layer, a method for forming the metal film layer may be electroplating the metal film layer on a surface of the adapter or the connector core. An electroplating process of the metal film layer may include the following steps.

Preprocessing of a base material: The base material may be the adapter or the connector core. First, polishing, cleaning, pickling, and other processing are performed on a surface of the base material to remove oxide, grease, and other impurities on the surface.

Electroplating activation/preprocessing: In some implementations, electroplating activation/preprocessing is performed on the base material to improve adhesion between the surface of the base material and the metal material.

Electroplating: The preprocessed base material is placed in an electroplating tank, and an anode of the metal material and a cathode of the base material are placed together. Through electrolysis, metal ions are deposited on the surface of the base material to form a film.

Rinsing with deionized water: After the electroplating is completed, deionized water is used to rinse the base material to remove electrolyte and other impurities that remain on the surface of the base material during the electroplating process.

Drying: The rinsed base material is dried to remove moisture.

The method for forming the metal film layer is merely an implementation, and process conditions vary with different electroplating materials. In addition, a surface of the metal film layer exposed to the outside may be further subject to processes such as anodizing and spraying. This is not specifically limited in this application.

In some other embodiments of this application, when the conductive layer 400 is a metal film layer, a method for forming the metal film layer may alternatively be: first forming a metal sheet, bending the metal sheet, and bringing the bent metal sheet into contact with the surface of the adapter or the connector core. For example, a conductive adhesive tape brings the bent metal sheet into contact with the surface of the adapter or the connector core.

In some other embodiments of this application, when the conductive layer 400 is a metal film layer, a method for forming the metal film layer may alternatively be: first forming a metal sheet, bending the metal sheet into a specific shape, and clamping the metal sheet in the specific shape to the surface of the adapter 200 or the first ferrule 110c.

In some other embodiments of this application, the conductive layer 400 may include an inorganic oxide film layer with good conductivity. For example, the conductive layer 400 may include at least one of an indium tin oxide film layer and a zinc oxide film layer.

In some other embodiments of this application, the conductive layer 400 may include a conductive polymer film layer. The conductive polymer film layer may include a poly(3,4-ethylenedioxythiophene) (PEDOT) film layer and/or a polyaniline (PANI) film layer. In the optical signal adapter system S2, the conductive polymer film layer has shape plasticity, thereby reducing difficulty in forming the conductive layer 400.

In some other embodiments of this application, the conductive layer 400 may include a graphene film layer. In the optical signal adapter system S2, the conductive layer 400 is a graphene film layer with good electrical conductivity, strength, and thermal conductivity, and is applicable to fields of high-performance electronic components, sensors, and the like.

It may be understood that conductive layers at another positions in this application may also be formed by using the foregoing formation solution of the conductive layer 400. Details are not described below.

After the specific formation manner of the conductive layer 400 is described, the following describes several arrangement solutions of a conductive layer 500 in detail with reference to the accompanying drawings.

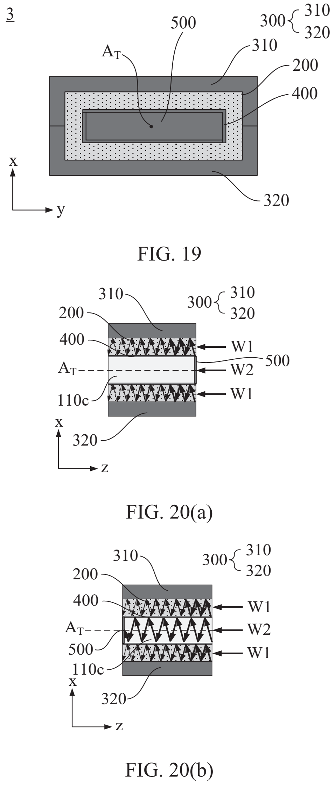

FIG. 19 is a sectional view obtained by cutting the optical signal adapter assembly 2 along the D-D section in FIG. 10(b) according to some embodiments of this application, where the first ferrule 110c is not shown. In some implementations, the D-D section in FIG. 10(b) passes through the conductive layer 500. In some other alternative implementations, the D-D section in FIG. 10(b) does not pass through the conductive layer 500.

FIG. 20(a) is a partial enlarged view of the area S2 in FIG. 11(b) according to some embodiments of this application, where transmission paths of electromagnetic waves W1 and W2 in the waveguide structure are illustrated. As shown in FIG. 20(a), the optical signal adapter assembly 2 includes the conductive layer 500, and the conductive layer 500 is disposed at a first end of the first ferrule 110c. Based on FIG. 20(a), it is not difficult to find that the conductive layer 500 blocks a channel through which the electromagnetic wave W2 enters the first ferrule 110c, causing the electromagnetic wave W2 to bypass the conductive layer 500 and enter the adapter 200 between the conductive layer 400 and the housing 300.

Based on this, in the optical signal adapter system S2, the optical signal adapter assembly 2 can further optimize the transmission path of the electromagnetic waves, increase a quantity of electromagnetic waves entering the adapter 200, further increase an electromagnetic wave loss caused by the optical signal adapter assembly 2, and further improve a shielding effect of the optical signal adapter assembly 2 against the electromagnetic waves.

In some embodiments of this application, the conductive layer 500 extends along a second direction, until the conductive layer 500 is in sealed contact with a surface of the conductive layer, so that the first end of the connector core 110 in the waveguide structure is in an isolated state relative to a second end, to block the transmission path of the electromagnetic waves from the first end to the second end of the connector core 110. The second direction intersects the insertion direction.

FIG. 20(b) is a partial enlarged view of the area S2 in FIG. 11(b) in some other embodiments of this application, where transmission paths of electromagnetic waves W1 and W2 in the waveguide structure are illustrated. As shown in FIG. 20(b), the optical signal adapter assembly 2 includes the conductive layer 500, and the conductive layer 500 is disposed at the second end of the first ferrule 110c. Based on FIG. 20(b), it is not difficult to find that, after the electromagnetic wave W2 enters the first ferrule 110c, the conductive layer 500 blocks a channel through which the electromagnetic wave W2 passes through the ferrule 110c, causing the electromagnetic wave W2 to bypass the conductive layer 500 and the conductive layer 400 and enter the adapter 200 between the conductive layer 400 and the housing 300.

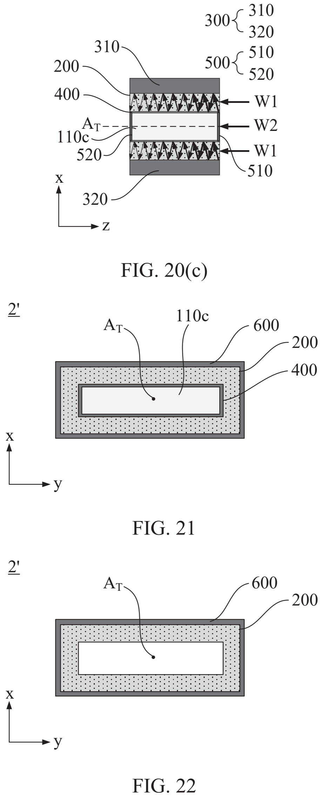

FIG. 20(c) is a partial enlarged view of the area S2 in FIG. 11(b) in some other embodiments of this application, where transmission paths of electromagnetic waves W1 and W2 in the waveguide structure are illustrated. As shown in FIG. 20(c), the optical signal adapter assembly 2 includes the conductive layer 500, and the conductive layer 500 includes a third conductive sublayer 510 and a fourth conductive sublayer 520. The third conductive sublayer 510 is disposed at the first end of the first ferrule 110c, and the fourth conductive sublayer 520 is disposed at the second end of the first ferrule 110c.

It may be understood that FIG. 20(a), FIG. 20(b), and FIG. 20(c) show the arrangement solutions of the conductive layer in some implementations of this application. Other technical solutions of the conductive layer 500 that can block the electromagnetic wave W2 also fall within the protection scope of this application. Details are not described herein.

This application further provides a ferrule. An optical fiber hole extending in a first insertion direction is provided in the ferrule, and an optical fiber can pass through the optical fiber hole in the first insertion direction. In addition, a conductive layer is formed on an outer surface of the ferrule.

In some embodiments of this application, in this application, the conductive layer on the outer surface of the ferrule at least partially encloses the ferrule around a first axis. The first axis is parallel to the first insertion direction.

This application further provides a connector structure. The connector structure includes any one of the foregoing ferrules, and a conductive layer is formed on an outer surface of the ferrule. Details are not described herein.

In some embodiments of this application, the connector structure corresponds to at least one of a multipurpose push-on/pull-off connector, a lucent connector, a standard connector, and an active optical cable connector.

This application further provides an adapter structure. The adapter structure includes any one of the foregoing adapters and a conductive layer. A material of the adapter includes a conductive filler and/or a magnetic filler, and the adapter encloses the conductive layer around the first axis. In some implementations, the conductive layer is formed in an annular shape around the first axis.

In some embodiments of this application, the adapter structure includes an adapter adapted to at least one of a multipurpose push-on/pull-off connector, a lucent connector, a standard connector, and an active optical cable connector.

In some embodiments of this application, in the adapter structure, the conductive filler includes but is not limited to at least one of a carbon fiber, a nickel-coated carbon fiber, a metal conductive particle, a metal conductive fiber, carbon black, graphite, and a carbon nanotube.

In some embodiments of this application, in the adapter structure, the magnetic filler includes but is not limited to at least one of ferrite, iron powder, nickel-iron powder, nickel-zinc ferrite, ferric hydroxide, and magnetic ceramics.

This application further provides a connector structure. The adapter structure includes any one of the foregoing adapters and a conductive layer. A material includes a conductive filler and/or a magnetic filler, a slot extending along a direction is provided in the adapter, and the slot is adapted to a ferrule. The conductive layer at least partially encloses the adapter around a first axis, and the first axis is parallel to a first direction. In some implementations, the conductive layer is formed in an annular shape around the first axis.

In some embodiments of this application, in the adapter structure, the conductive filler includes but is not limited to at least one of a carbon fiber, a nickel-coated carbon fiber, a metal conductive particle, a metal conductive fiber, carbon black, graphite, and a carbon nanotube.

In some embodiments of this application, in the adapter structure, the magnetic filler includes but is not limited to at least one of ferrite, iron powder, nickel-iron powder, nickel-zinc ferrite, ferric hydroxide, and magnetic ceramics.

This application further provides an optical signal adapter system S2. The optical signal adapter system S2 includes at least one of the foregoing optical signal adapter assemblies 2 and two optical modules. The two optical modules implement optical signal adaptation by using the optical adapter assembly 2.

This application further provides an electronic device. The electronic device includes any one of the foregoing optical signal adapter systems S2. It may be understood that the electronic device may be a type of optical communication device such as an optical switch, an optical transceiver, an optical router, an optical fiber transceiver, or an optical transport network device.

### Application scenario 2

FIG. 21 is a sectional view of an optical signal adapter assembly 2' along a C-C section in FIG. 10(b) according to some embodiments of this application. As can be learned by comparing FIG. 21 with FIG. 11(a), a difference between the optical signal adapter assembly 2' in the application scenario 2 and the optical signal adapter assembly 2 in the application scenario 1 lies in that the optical signal adapter assembly 2' does not include a housing 300, but a conductive layer 600 is added on a surface of one side that is of an adapter 200 and that faces away from a first ferrule 110c. A conductive layer 400 is used as a first conductive layer, the adapter 200 is used as a dielectric layer, and the conductive layer 600 is used as a second conductive layer to form a concentric-square waveguide structure.

In some embodiments of this application, the conductive layer 600 is a film-like structure that rotates around a transmission axis. In some implementations, a thickness of the conductive layer 600 ranges from 1 µm to 500 µm. The thickness of the conductive layer 600 is a size of the conductive layer 600 in a direction perpendicular to the transmission axis, that is, a distance from a surface of one side that is of the conductive layer 600 and that faces toward the adapter 200 to a surface of one side that is of the conductive layer 600 and that faces away from the adapter 200, on one side of the transmission axis. For example, the thickness of the conductive layer 600 is any one of 1 µm, 10 µm, 20 µm, 30 µm, 40 µm, 50 µm, 100 µm, 150 µm, 200 µm, 250 µm, 300 µm, 350 µm, 400 µm, 450 µm, and 500 µm.

FIG. 22 is a diagram of the conductive layer 600 formed on the adapter 200 in the optical signal adapter system 2' according to some embodiments of this application. As shown in FIG. 22, the conductive layer 500 is formed on a surface of one side that is of the adapter 200 and that faces away from the first ferrule 110c.

This application further provides a ferrule. For details, refer to the ferrule in the application scenario 1. Details are not described herein again.

This application further provides a connector structure. For details, refer to the connector structure in the application scenario 1. Details are not described herein again.

This application further provides an adapter structure. For details, refer to the adapter structure in the application scenario 1. Details are not described herein again.

This application further provides an optical signal adapter system. For details, refer to the optical signal adapter system in the application scenario 1. Details are not described herein again.

This application further provides an electronic device. For details, refer to the electronic device in the application scenario 1. Details are not described herein again.

### Application scenario 3

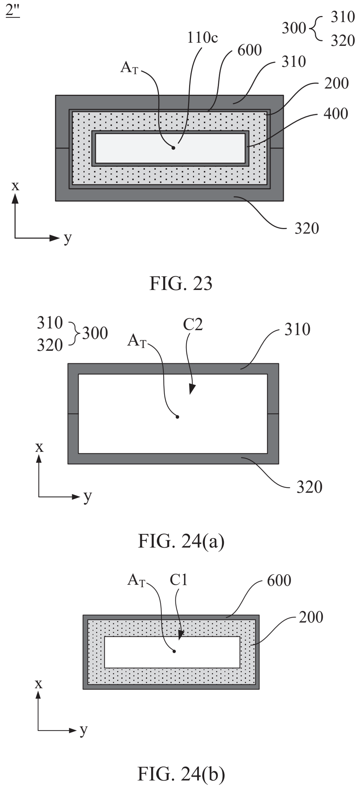

FIG. 23 is a sectional view of an optical signal adapter assembly 2" along a C-C section in FIG. 10(b) according to some embodiments of this application. As can be learned by comparing FIG. 23 with FIG. 11(a), the optical signal adapter assembly 2" in the application scenario 3 is an integration of the optical signal adapter assembly 2 in the application scenario 1 and the optical signal adapter assembly 2' in the application scenario 2. In other words, the optical signal adapter assembly 2" includes both a housing 300 and a conductive layer 600.

FIG. 24(a) is a diagram of the housing 300 in the optical signal adapter assembly 2" according to some embodiments of this application. As shown in FIG. 24(a), an installation channel C2 that penetrates through the housing along an insertion direction is formed in the housing 300. FIG. 24(b) is a diagram of the conductive layer 600 formed on an adapter 200 in the optical signal adapter assembly 2" according to some embodiments of this application. As shown in FIG. 24(b), the conductive layer 500 is formed on a surface of one side that is of the adapter 200 and that faces away from a first connector core 110c.

This application further provides a ferrule. For details, refer to the ferrule in the application scenario 1. Details are not described herein again.

This application further provides a connector structure. For details, refer to the connector structure in the application scenario 1. Details are not described herein again.

This application further provides an adapter structure. For details, refer to the adapter structure in the application scenario 1. Details are not described herein again.

This application further provides an optical signal adapter system. For details, refer to the optical signal adapter system in the application scenario 1. Details are not described herein again.

This application further provides an electronic device. For details, refer to the electronic device in the application scenario 1. Details are not described herein again.

### Application scenario 4

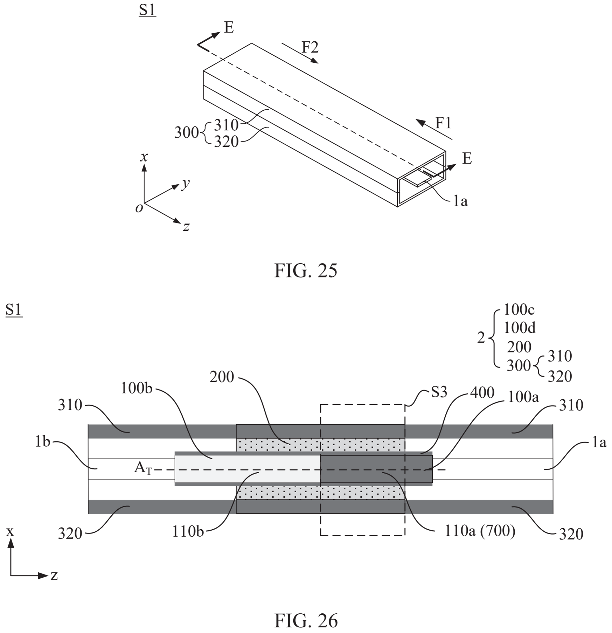

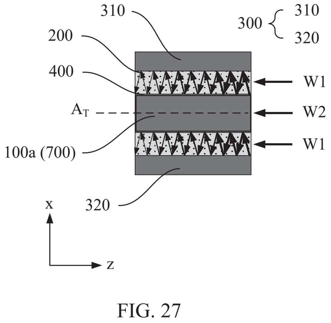

FIG. 25 is a three-dimensional view of an optical signal adapter system S1 according to some embodiments of this application. FIG. 26 is a sectional view of the optical signal adapter system S1 along an E-E section in FIG. 25 according to some embodiments of this application. FIG. 27 is a partial enlarged view of an area S3 in FIG. 26. As can be learned by comparing FIG. 27 with FIG. 20(a), FIG. 20(b), and FIG. 20(c), the optical signal adapter system S1 in the application scenario 4 corresponds to an optical signal adapter solution between an optical transceiver module 1a and an optical fiber (not shown in the figure).

A difference from the application scenario 1, the application scenario 2, and the application scenario 3 lies in that a solution of a conductive layer 500 in the application scenario 4 may be adjusted. For example, in the optical signal adapter system S1, an optical component 100a in an optical signal adapter assembly 2 is made of a conductor material, that is, the optical component 100a is a conductive structure 700, and opposite surfaces of the conductive structure 700 and a conductive layer 400 are in close contact. It may be understood that the conductive structure 700 may be used as the conductive layer 500 to block an electromagnetic wave W2. Based on FIG. 27, it is not difficult to find that, after the electromagnetic wave W2 enters a first ferrule 110c, the conductive structure 700 blocks a channel through which the electromagnetic wave W2 passes through the optical component 100a, causing the electromagnetic wave W2 to bypass the conductive structure 700 and the conductive layer 400 and enter an adapter 200 between the conductive layer 400 and a housing 300.

It may be understood that, in some embodiments of this application, when the optical signal adapter assembly 2 includes the conductive structure 700, the conductive layer 400 may not be disposed, and a function of the conductive layer 400 is implemented by using the conductive structure 700. Details are not described herein.

This application further provides an optical component, where the optical component is made of a conductive material.

This application further provides a connector structure, including any one of the foregoing optical components.

This application further provides an adapter structure. For details, refer to the adapter structure in the application scenario 1. Details are not described herein again.

This application further provides an optical signal adapter system. For details, refer to the optical signal adapter system in the application scenario 1. Details are not described herein again.

This application further provides an electronic device. For details, refer to the electronic device in the application scenario 1. Details are not described herein again.

It should be noted that, in this specification, similar reference numerals and letters in the following accompanying drawings represent similar items. Therefore, once an item is defined in an accompanying drawing, the item does not need to be further defined or interpreted in the following accompanying drawings.

The foregoing describes implementations of this application in specific embodiments, and other advantages and effects of this application may be readily understood by a person skilled in the art from content disclosed in this specification. Although this application is described with reference to some embodiments, it does not mean that a characteristic of this application is limited only to this implementation. On the contrary, a purpose of describing this application with reference to the implementations is to cover other alternatives or modifications that may be derived based on claims of this application. To provide an in-depth understanding of this application, the following descriptions include a plurality of specific details. This application may alternatively be implemented without using these details. In addition, to avoid confusion or obscuring a focus of this application, some specific details are omitted in the description. It should be noted that embodiments and features in embodiments in this application may be combined with each other in absence of conflicts.

In the descriptions of this application, it should be noted that, directions or position relationships indicated by terms such as "center", "up", "down", "left", "right", "vertical", "horizontal", "outer side", "inner side", "a circumferential direction", "a radical direction", and "an axial direction" are based on the directions or position relationships shown in the accompanying drawings, and are merely intended to describe this application and simplify the descriptions, but are not intended to indicate or imply that an indicated apparatus or element needs to have a specific direction or be constructed and operated in a specific direction, and therefore cannot be understood as a limitation on this application.

In the descriptions of this application, it should be noted that unless otherwise explicitly specified and defined, terms such as "dispose", "mount", "connect", and "contact" should be understood in a broad sense. For example, such terms may indicate a fixed connection, a detachable connection, or an integral connection, may indicate a mechanical connection or an electrical connection, and may indicate a direct connection, an indirect connection through an intermediate medium, or an internal communication between two elements. For a person of ordinary skill in the art, specific meanings of the terms in this application may be understood based on a specific situation.

It is clear that a person skilled in the art can make various modifications and variations to this application without departing from the spirit and scope of this application.

This application is intended to cover these modifications and variations of this application provided that they fall within the protection scope defined by the following claims and equivalent technologies thereof.

## Claims

1. An optical signal adapter assembly, wherein the optical signal adapter assembly is configured to connect a first optical module to a second optical module to implement transmission of an optical signal from the first optical module to the second optical module, and the optical signal adapter assembly comprises:
a connector core, wherein the connector core is configured to connect to the first optical module;
a first conductive layer, wherein the first conductive layer encloses the connector core around a transmission axis, and the transmission axis is parallel to a transmission direction of the optical signal;
an adapter, wherein a material of the adapter comprises a conductive filler and/or a magnetic filler, and the adapter encloses the first conductive layer around the transmission axis; and
a second conductive layer, wherein the second conductive layer encloses the adapter around the transmission axis.

2. The optical signal adapter assembly according to claim 1, wherein the first conductive layer is formed on one of two opposite surfaces of the connector core and the adapter.

3. The optical signal adapter assembly according to claim 1 or 2, wherein a mass doping percentage of the conductive filler and/or the magnetic filler ranges from 0.5% to 40%.

4. The optical signal adapter assembly according to any one of claims 1 to 3, wherein the first conductive layer is a film-like structure that rotates around the transmission axis; and/or the second conductive layer is a film-like structure that rotates around the transmission axis.

5. The optical signal adapter assembly according to claim 1, wherein
the first conductive layer comprises a first conductive sublayer and a second conductive sublayer, and the first conductive sublayer and the second conductive sublayer cooperate with each other to enclose the connector core around the transmission axis; and
the first conductive sublayer is formed on a surface that is of the connector core and that faces toward the adapter, and the second conductive sublayer is formed on a surface that is of the adapter and that faces toward the connector core.

6. The optical signal adapter assembly according to any one of claims 1 to 5, wherein the second conductive layer is formed on a surface that is of the adapter and that faces away from the connector core.

7. The optical signal adapter assembly according to any one of claims 1 to 5, wherein the optical signal adapter assembly further comprises a conductive housing, and the conductive housing is the second conductive layer.

8. The optical signal adapter assembly according to any one of claims 1 to 5, wherein the optical signal adapter assembly comprises a conductive housing, and the connector core, the first conductive layer, the adapter, and the second conductive layer are located in the conductive housing;
the second conductive layer comprises a third conductive sublayer and a fourth conductive sublayer, and the third conductive sublayer and the fourth conductive sublayer cooperate with each other to enclose the adapter around the transmission axis; and
the third conductive sublayer is formed on a surface of the adapter, and the fourth conductive sublayer is formed on a surface of the conductive housing.

9. The optical signal adapter assembly according to any one of claims 1 to 8, wherein the conductive filler comprises at least one of a carbon fiber, a nickel-coated carbon fiber, a metal conductive particle, a metal conductive fiber, carbon black, graphite, and a carbon nanotube.

10. The optical signal adapter assembly according to any one of claims 1 to 9, wherein the magnetic filler comprises at least one of ferrite, iron powder, nickel-iron powder, nickel-zinc ferrite, ferric hydroxide, and magnetic ceramics.

11. The optical signal adapter assembly according to any one of claims 1 to 10, wherein two opposite surfaces of the connector core and the first conductive layer are in sealed contact with each other, and the connector core is made of a conductive material.

12. The optical signal adapter assembly according to any one of claims 1 to 10, wherein the optical signal adapter assembly further comprises a third conductive layer, and the third conductive layer is disposed on the connector core and extends along a direction intersecting the transmission axis, until the third conductive layer is in sealed contact with a surface of the first conductive layer.

13. A connector structure, wherein the connector structure comprises:
a connector core, wherein the connector core is configured to connect to the optical module; and
a fourth conductive layer, wherein the fourth conductive layer at least partially encloses the connector core around a transmission axis, and the transmission axis is parallel to a transmission direction of an optical signal.

14. The connector structure according to claim 13, wherein the connector structure comprises at least one of a multipurpose push-on/pull-off connector, a lucent connector, a standard connector, and an active optical cable connector.

15. An adapter structure, wherein the adapter structure comprises:
a fifth conductive layer, wherein the fifth conductive layer is formed in an annular shape around a transmission axis, and the transmission axis is parallel to a transmission direction of the optical signal; and
an adapter, wherein a material of the adapter comprises a conductive filler and/or a magnetic filler, and the adapter encloses the fifth conductive layer around the first axis.

16. The adapter structure according to claim 15, wherein the conductive filler comprises at least one of a carbon fiber, a nickel-coated carbon fiber, a metal conductive particle, a metal conductive fiber, carbon black, graphite, and a carbon nanotube.

17. The adapter structure according to claim 15 or 16, wherein the magnetic filler comprises at least one of ferrite, iron powder, nickel-iron powder, nickel-zinc ferrite, ferric hydroxide, and magnetic ceramics.

18. An adapter structure, wherein the adapter structure comprises:
an adapter, wherein the adapter comprises a conductive filler and/or a magnetic filler, a slot for inserting a connector core is provided in the adapter, and the slot extends along a transmission direction of an optical signal; and
a sixth conductive layer, wherein the sixth conductive layer at least partially encloses the adapter around a transmission axis, and the transmission axis is parallel to the transmission direction of the optical signal.

19. The adapter structure according to claim 18, wherein the conductive filler comprises at least one of a carbon fiber, a nickel-coated carbon fiber, a metal conductive particle, a metal conductive fiber, carbon black, graphite, and a carbon nanotube.

20. The adapter structure according to claim 18 or 19, wherein the magnetic filler comprises at least one of ferrite, iron powder, nickel-iron powder, nickel-zinc ferrite, ferric hydroxide, and magnetic ceramics.

21. An optical signal adapter system, wherein the optical signal adapter system comprises the optical signal adapter assembly according to any one of claims 1 to 12, a first optical module, and a second optical module, wherein the first optical module and the optical module implement optical signal adaptation by using the optical adapter assembly.

22. An electronic device, comprising the optical signal adapter system according to claim 20.
